(19)

Europäisches
Patentamt

European
Patent Office

Office européen
des brevets

(11) **EP 4 312 036 A1**

(12) **EUROPEAN PATENT APPLICATION**

(43) Date of publication:
**31.01.2024 Bulletin 2024/05**

(21) Application number: **23187703.6**

(22) Date of filing: **25.07.2023**

(51) International Patent Classification (IPC):
**G01R 27/28** *(2006.01)*  **G01R 27/32** *(2006.01)*
**G01R 35/00** *(2006.01)*

(52) Cooperative Patent Classification (CPC):
**G01R 27/28; G01R 27/32; G01R 35/005**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **26.07.2022 CN 202210887458**

(71) Applicant: **Nokia Solutions and Networks Oy 02610 Espoo (FI)**

(72) Inventor: **GAO, Jun Shanghai, 201109 (CN)**

(74) Representative: **DREISS Patentanwälte PartG mbB Friedrichstraße 6 70174 Stuttgart (DE)**

(54) **A METHOD AND AN APPARATUS OF MEASUREMENT, RADIO FREQUENCY EQUIPMENT AND COMPUTER-READABLE MEDIUM**

(57) Embodiments of the present disclosure relate to a method and an apparatus of measurement, a radio frequency equipment and a computer-readable medium. One embodiment of the method comprises: during the runtime of a radio frequency equipment, obtaining, by a coupler in the radio frequency equipment, a forward measurement signal from a first radio frequency device to a second radio frequency device of the radio frequency equipment and a reverse measurement signal from the second radio frequency device to the first radio frequency device; determining, based on the forward measurement signal, the reverse measurement signal and offline calibration data, a reflection coefficient at a measurement reference plane between the coupler and the second radio frequency device; and determining, based on the reflection coefficient at the measurement reference plane, a reflection coefficient at a calibration reference plane between the second radio frequency device and a load of the radio frequency equipment. In this way, there is no need to add too more hardware circuits, thereby saving hardware cost, and there is no need to add a complex real-time running algorithm, thereby reducing the CPU load and further ensuring the measurement accuracy.

EP 4 312 036 A1

**Description**

**FIELD**

Various example embodiments relate to the field of communications, and more particularly, to a method of measurement, a radio frequency equipment, an apparatus of measurement, and a computer-readable medium.

**BACKGROUND**

In general, a radio frequency equipment refers to an electronic equipment used for receiving and transmitting a radio frequency signal or performing other processing on the radio frequency signal. In production and use, there is a strict requirement for the radio frequency performance of the radio frequency equipment in general. However, the accuracy of measurement and calibration of various performance parameters of the radio frequency equipment still needs to be further improved.

**SUMMARY**

In general, example embodiments of the present disclosure relate to a method of measurement, a radio frequency equipment, an apparatus of measurement, and a computer-readable medium.

In a first aspect of the present disclosure, there is provided a method of measurement. The method of measurement comprises: during runtime of a radio frequency equipment, obtaining, by a coupler in the radio frequency equipment, a forward measurement signal from a first radio frequency device to a second radio frequency device of the radio frequency equipment and a reverse measurement signal from the second radio frequency device to the first radio frequency device; determining, based on the forward measurement signal, the reverse measurement signal and offline calibration data, a reflection coefficient at a measurement reference plane between the coupler and the second radio frequency device; and determining, based on the reflection coefficient at the measurement reference plane, a reflection coefficient at a calibration reference plane between the second radio frequency device and a load of the radio frequency equipment.

In a second aspect of the present disclosure, there is provided a radio frequency equipment. The radio frequency equipment comprises at least one processor and at least one memory storing instructions that, when executed by the at least one processor, cause the radio frequency equipment at least to: during runtime of the radio frequency equipment, obtain, by a coupler in the radio frequency equipment, a forward measurement signal from a first radio frequency device to a second radio frequency device of the radio frequency equipment and a reverse measurement signal from the second radio frequency device to the first radio frequency device; determine, based on the forward measurement signal, the reverse measurement signal and offline calibration data, a reflection coefficient at a measurement reference plane between the coupler and the second radio frequency device; and determining, based on the reflection coefficient at the measurement reference plane, a reflection coefficient at a calibration reference plane between the second radio frequency device and a load of the radio frequency equipment.

In a third aspect of the present disclosure, there is provided a measurement apparatus. The apparatus comprises: means for, during runtime of a radio frequency equipment, obtaining, by a coupler in the radio frequency equipment, a forward measurement signal from a first radio frequency device to a second radio frequency device of the radio frequency equipment and a reverse measurement signal from the second radio frequency device to the first radio frequency device; means for determining, based on the forward measurement signal, the reverse measurement signal and offline calibration data, a reflection coefficient at a measurement reference plane between the coupler and the second radio frequency device; and means for determining, based on the reflection coefficient at the measurement reference plane, a reflection coefficient at a calibration reference plane between the second radio frequency device and a load of the radio frequency equipment.

In a fourth aspect of the present disclosure, there is provided a computer-readable medium. The computer-readable medium comprises program instructions stored thereon for performing at least the method according to the first aspect.

In a fifth aspect of the present disclosure, there is provided a computer program comprising instructions, which, when executed by an apparatus, cause the apparatus to at least execute the method according to the first aspect.

In a sixth aspect of the present disclosure, there is provided a radio frequency equipment. The radio frequency equipment comprises: a reverse measurement signal obtaining circuitry configured to, during runtime of the radio frequency equipment, obtain, by a coupler in the radio frequency equipment, a forward measurement signal from a first radio frequency device to a second radio frequency device of the radio frequency equipment and a reverse measurement signal from the second radio frequency device to the first radio frequency device; a reflection coefficient at a measurement reference plane determining circuitry configured to determine, based on the forward measurement signal, the reverse measurement signal and offline calibration data, a reflection coefficient at a measurement reference plane between the coupler and the second radio frequency device; and a reflection coefficient at a calibration reference plane determining circuitry configured to determine, based on the reflection coefficient at the measurement reference plane, a reflection coefficient at a calibration reference plane between the second radio frequency device and a load of the radio frequency equipment.

It is to be understood that the summary section is not intended to identify key or essential features of embodiments of the present disclosure, nor is it intended to be used to limit the scope of the present disclosure. Other features of the present disclosure will become easily comprehensible through the following description.

## BRIEF DESCRIPTION OF THE DRAWINGS

Fig. 1 illustrates a block diagram of an example communication system in which the embodiments of the present disclosure may be implemented;

Fig. 2 illustrates a schematic diagram of a VSWR measurement solution;

Fig. 3 illustrates a schematic diagram of an interference compensation solution based on a hardware circuit and offline calibration;

Fig. 4 illustrates a schematic flowchart of a method of measurement according to some embodiments of the present disclosure;

Fig. 5 illustrates a schematic flowchart of determining a reflection coefficient at a measurement reference plane according to some embodiments of the present disclosure;

Fig. 6 illustrates a schematic diagram of an equipment-level calibration flow executed by a radio frequency equipment according to some embodiments of the present disclosure;

Fig. 7 illustrates a schematic flowchart of determining a first plurality of reflection coefficients at the measurement reference plane when the radio frequency equipment is respectively connected to a plurality of calibration loads with different impedances according to some embodiments of the present disclosure;

Fig. 8 illustrates a schematic diagram of an error model according to some embodiments of the present disclosure;

Fig. 9 illustrates a schematic diagram of an overall architecture of VSWR measurement according to some embodiments of the present disclosure;

Fig. 10 illustrates a detailed schematic diagram of relevant circuits at a measurement reference plane and a calibration reference plane according to some embodiments of the present disclosure;

Fig. 11 illustrates a schematic diagram of calculating a relevant parameter table for calculating a reverse signal caused by return losses of a filter and a load according to some embodiments of the present disclosure;

Fig. 12 illustrates a schematic diagram of a difference between $|S_{RM}|$ and $|S_{RWM}|$ caused by a return loss (RL) of a cavity filter according to some embodiments of the present disclosure;

Fig. 13 illustrates a schematic diagram of data for evaluating leakage from a total vector signal of forward detection to a reverse detection port of SPDT (single-pole double-throw switch) according to some embodiments of the present disclosure;

Fig. 14 illustrates a schematic diagram of leakage from a forward port to a reverse port according to some embodiments of the present disclosure;

Fig. 15 illustrates a schematic diagram of data for evaluating leakage from $\overrightarrow{S_{RDT}}$ to a forward detection port of SPDT according to some embodiments of the present disclosure.

Fig. 16 illustrates a schematic diagram of leakage from the reverse port to the forward port according to some embodiments of the present disclosure;

Fig. 17 illustrates a schematic diagram of data for calculating SPDT's leakage in a spectrum analyzer (SA) mode according to some embodiments of the present disclosure;

Fig. 18 (i), Fig. 18 (ii), Fig. 18 (iii) and Fig. 18 (iv) illustrate schematic diagrams of data for calculating leakage of a MUX according to some embodiments of the present disclosure;

Fig. 19 illustrates a schematic diagram of device-level offline calibration of a bi-direction coupler according to some embodiments of the present disclosure;

Fig. 20 illustrates a schematic diagram of data for calculating a reverse leakage signal according to some embodiments of the present disclosure;

Fig. 21 illustrates a schematic diagram of surface mounting process steps of a coupler according to some embodiments of the present disclosure;

Fig. 22 illustrates a schematic diagram of half-box-level offline calibration according to some embodiments of the present disclosure;

Fig. 23 illustrates a schematic diagram of RRU-level offline calibration according to some embodiments of the present disclosure;

Fig. 24 illustrates a schematic diagram of VSWR calibration and measurement according to some embodiments of the present disclosure;

Fig. 25 illustrates a schematic diagram of a measurement flow of a voltage stand wave ratio according to some embodiments of the present disclosure;

Fig. 26 illustrates a simplified block diagram of an electronic equipment that is suitable for implementing embodiments of the present disclosure;

Fig. 27 illustrates a schematic diagram of a computer-readable medium suitable for implementing embodiments of the present disclosure.

Throughout the drawings, the same or similar reference numerals represent the same or similar element.

## DETAILED DESCRIPTION

The principles and spirit of the present disclosure will be described below with reference to several example embodiments shown in the drawings. It should be understood that, these specific embodiments are described only to enable those skilled in the art to better understand and implement the present disclosure, and not to limit the scope of the present disclosure in any way.

As used herein, the term "comprising" and similar terms thereof should be understood as open-ended inclusions, that is, "including but not limited to". The term "based on" should be understood to be "at least partially based on". The term "one embodiment" or "the embodiment" should be understood as "at least one embodiment". The terms "first", "second" and the like may refer to different or the same objects. Other explicit and implicit definitions may also be included below.

As used herein, the term "determining" encompasses a variety of actions. For example, "determining" may include operation, computing, processing, deriving, investigating, searching (for example, searching in a table, a database, or another data structure), ascertaining, and the like. Further, "determining" may include receiving (for example, receiving information), accessing (for example, accessing data in a memory), etc. In addition, "determining" may include parsing, choosing, selecting, establishing, etc.

As used herein, "at least one of the following: <a list of two or more elements>" and "at least one of <a list of two or more elements>" and similar wording, where the list of two or more elements are joined by "and" or "or", mean at least any one of the elements, or at least any two or more of the elements, or at least all the elements.

As used in this application, the term "circuitry" may refer to one or more or all of the following: (a) hardware-only circuit implementations (such as implementations in only analog and/or digital circuitry) and (b) combinations of hardware circuits and software, such as (as applicable): (i) a combination of analog and/or digital hardware circuit(s) with software/firmware and (ii) any portions of hardware processor(s) with software (including digital signal processor(s)), software, and memory(ies) that work together to cause an apparatus, such as a mobile phone or server, to perform various functions) and (c) hardware circuit(s) and or processor(s), such as a microprocessor(s) or a portion of a microprocessor(s), that requires software (e.g., firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in other computing device.

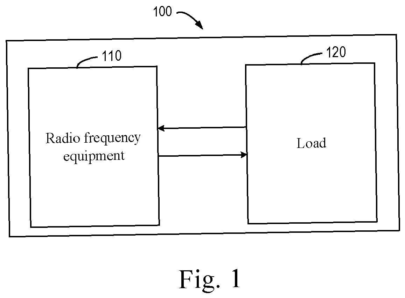

Fig. 1 illustrates a block diagram of an example communication system in which the embodiments of the present disclosure may be implemented. As shown in Fig. 1, the communication system 100 comprises a radio frequency equipment 110 and a load 120, and the radio frequency equipment 110 is connected with the load 120 by a feeder line. In order to judge the connection performance between the radio frequency equipment 110 and the load 120, the voltage stand wave ratio of the load 120 needs to be measured. The specific composition of the radio frequency equipment 110 is not shown in Fig. 1, and according to the specific type of the radio frequency equipment 110, for example, a RRU and other equipment, there may be differences in the specific composition, but the radio frequency equipment 110 generally comprises a radio frequency unit, a power amplifier, and the like. Specific examples of the composition of the radio frequency equipment 110 may refer to other Figs of the embodiments of the present disclosure.

In some embodiments, the radio frequency equipment may be a RRU. Although an AAU (Active Antenna Unit) is becoming more and more popular in 5G for the function of massive multiple-input multiple-output (MIMO) to bring out great capacity, but the RRU (radio remote unit) is still quite important in those scenarios where the key question is not capacity but coverage. This means RRU with a low-cost and a low-power consumption is good enough in those areas (e.g., suburbs), even for 5G and behind 5G. When the radio frequency equipment is an RRU, the load 120 may be an antenna feed system.

In other embodiments, the load 120 may also be any other suitable load. Taking the load 120 being an antenna feed system as an example, since for the radio frequency equipment 110, the radio frequency (RF) unit and an antenna are still not integrated, and it is possible that the connection between the radio frequency equipment 110 and the antenna feed system is bad, such as a feed cable connector is rusty or water-logged. As a result, a strong reverse signal will damage the radio frequency equipment 110, in particular a PA (power amplifier). Therefore, a software mechanism of VSWR (voltage stand wave ratio) measurement is needed to protect the radio frequency equipment 110 by monitoring the connection between the radio frequency equipment 110 and the load 120 (e.g., the antenna feed system). In terms of the construction of a mobile network infrastructure, the radio frequency equipment 110 (e.g., the RRU) is a network element with the largest shipment amount, which could contribute to the largest share of revenue in mobile network services. When the radio frequency equipment 110 is connected to the load 120 such as an antenna feed system in the field, the VSWR measurement and alarm report of the radio frequency equipment 110 are very important.

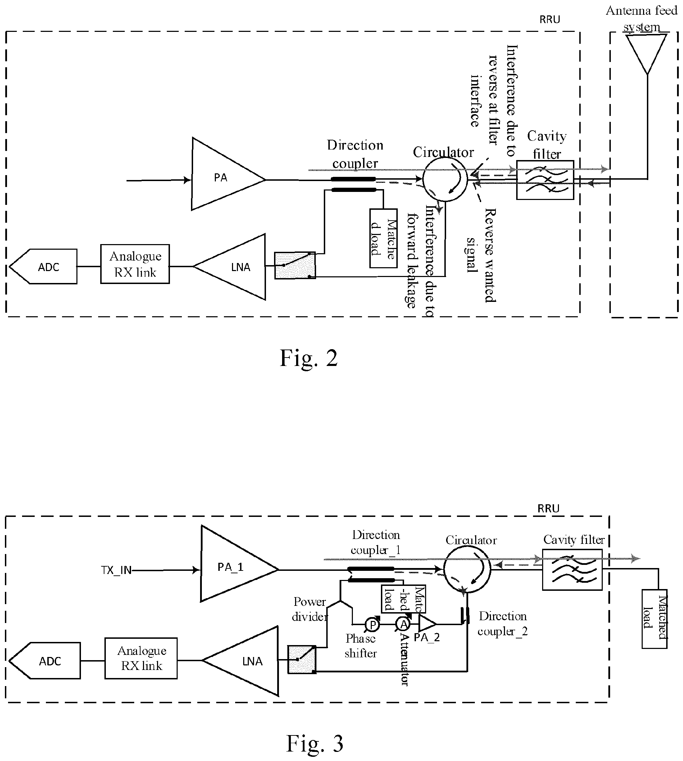

Due to the interference of other unwanted reverse signals and the leakage of unwanted forward signals, a general measurement system used for measuring a reflection coefficient (or VSWR) of the radio frequency equipment cannot accurately measure the reflection coefficient or the VSWR. For example, as shown in Fig. 2, it is a schematic diagram of a reflection coefficient or VSWR measurement solution, and in Fig. 2, a dashed arc line represents interference due to forward leakage from a circulator into a reverse detector. A dashed straight line represents interference due to a reflection at a filter interface. The above both signals are unwanted, but the reflection coefficient or VSWR measurement method described in Fig. 2 includes the two signals. So the result is inaccurate, which will cause false alarms or missing real alarms.

Fig. 3 is a schematic diagram of an interference compensation solution based on a hardware circuit and offline calibration. As can be seen according to Fig. 3, this solution uses a phase shifter and an attenuator to compensate the total interference with matched load at an RRU antenna port. The solution has the following weakness: 1) the hardware cost is increased, and the solution is only used for offline calibration, but not for online runtime usage. 2) Wanted phases and amplitude values are get by using an exhaustive method (or other search methods), which spends lots of time, and iteration results may not converge. 3) The value of the attenuator is just for special (maximum) output power, but the real output power is fluctuating with the real traffic. Therefore, the solution is not suitable for runtime measurement.

Another solution is to use a correlation coefficient to compensate a forward interference signal, but this solution may compensate the forward interference signal only when an unwanted forward signal leaks into a reverse detection port. Other unwanted reverse interference (e.g., unwanted reverse vector signals on a measurement reference plane) cannot be eliminated.

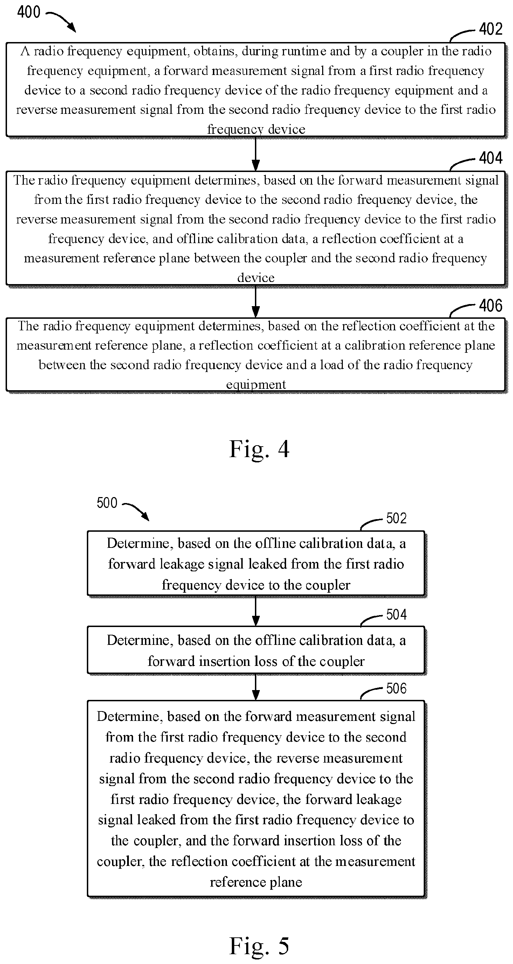

In order to solve the technical problems in the above solutions, in the embodiments of the present disclosure, offline vector calibration is performed at a reflection coefficient (or VSWR) detector port (for a measurement reference plane) or at an antenna port (for a calibration reference plane). In addition, an real reflection coefficient (or VSWR) at the calibration reference plane is obtained according to the online measurement of an S parameter (scattering parameter, i.e., the reflection coefficient) on the measurement reference plane. Therefore, there is no need to add too more hardware circuits, such that the hardware cost can be saved, and there is no need to add a complex runtime algorithm, thereby reducing the CPU load. At the same time, the solution of the embodiments of the present disclosure also guarantee the measurement accuracy. The embodiments of the present disclosure are described in detail below based on Fig. 4 to Fig. 25.

Fig. 4 illustrates a schematic flowchart of a method 400 of measurement according to some embodiments of the present disclosure. As shown in Fig. 4, at block 402, a radio frequency equipment 110 obtains, during runtime and by a coupler in the radio frequency equipment 110, a forward measurement signal from a first radio frequency device to a second radio frequency device of the radio frequency equipment 110 and a reverse measurement signal from the second radio frequency device to the first radio frequency device.

Those skilled in the art may understand that, from the first radio frequency device to the second radio frequency device indicates the direction of the forward measurement signal, and the direction is referred to as a forward direction in the embodiments of the present disclosure. From the second radio frequency device to the first radio frequency device indicates the direction of the reverse measurement signal, and the direction is referred to as a reverse direction in the embodiments of the present disclosure.

At block 404, the radio frequency equipment 110 determines, based on the forward measurement signal from the first radio frequency device to the second radio frequency device, the reverse measurement signal from the second radio frequency device to the first radio frequency device, and offline calibration data, a reflection coefficient, which is denoted as ($\overrightarrow{S11_{M\_runtime}}$), at a measurement reference plane between the coupler and the second radio frequency device .

In some embodiments, the forward measurement signal (denoted as $|\overrightarrow{s_{FDT}}|$) from the first radio frequency device to the second radio frequency device includes a real forward measurement signal (denoted as $|\overrightarrow{s_{RFD}}|$) from the first radio frequency device to the second radio frequency device, and further includes a reverse leakage signal (denoted as $\overrightarrow{s_{RLD}}$) leaking from the second radio frequency device to the coupler. In the embodiments of the present disclosure, the reverse leakage signal leaking from the second radio frequency device to the coupler is ignored, and the forward measurement signal from the first radio frequency device to the second radio frequency device is used as the real forward measurement signal from the first radio frequency device to the second radio frequency device, so as to calculate the reflection coefficient at the measurement reference plane between the coupler and the second radio frequency device. The reason why $\overrightarrow{s_{RLD}}$ may be ignored will be described in detail below.

In some embodiments, the reverse measurement signal (denoted as $\overrightarrow{S_{RDT}}$) from the second radio frequency device to the first radio frequency device may comprise a real reverse measurement signal (denoted as $\overrightarrow{S_{RRD}}$) from the second radio frequency device to the first radio frequency device, and a forward leakage signal (denoted as $\overrightarrow{S_{FLD}}$) leaking from the first radio frequency device to the coupler.

At block 406, the radio frequency equipment 110 determines, based on the reflection coefficient at the measurement reference plane, a reflection coefficient, which is denoted as $\overrightarrow{S_{11C\_runtime}}$, at a calibration reference plane between the second radio frequency device and a load 120 of the radio frequency equipment 110.

According to the measurement method of the embodiments of the present disclosure, the measurement accuracy of the reflection coefficient at the calibration reference plane between the loads 120 of the radio frequency equipment 110 can be improved, and the increase in the hardware cost is relatively small.

In some embodiments, the load 120 mentioned in the method 400 of measurement may be an antenna feed system.

The running of the radio frequency equipment 110 in the embodiments of the present disclosure, that is, an online state of the radio frequency equipment 110, is relative to an offline state. In some embodiments, when the radio frequency equipment 110 is running, the load 120 connected with the radio frequency equipment 110 may be an antenna feed system. In contrast, when the radio frequency equipment 110 is offline, the load 120 connected with the radio frequency equipment 110 may be one or more loads 120 such as impedance(s) and a spectrum analyzer (SA).

In some embodiments, when the radio frequency equipment 110 is offline, when different types of loads 120 need to be connected in sequence, the load 120 connected at a certain moment may be switched by a single-pole multi-throw switch.

In some embodiments, operations performed by the radio frequency equipment 110 in the offline state (for example, operations performed during an offline calibration process mentioned in the embodiments of the present disclosure) may be implemented before the radio frequency equipment 110 leaves the factory (i.e., in a production phase). Operations performed by the radio frequency equipment 110 in the online state (runtime) are implemented when the radio frequency equipment 110 is connected with the load 120 such as an antenna feed system, when the radio frequency equipment 110 is actually running after leaving the factory.

In some embodiments, the radio frequency equipment 110 may be a remote radio unit (RRU), the coupler is a bi-direction coupler, the first radio frequency device is a circulator, and the second radio frequency device is a cavity filter.

In some other embodiments, the radio frequency equipment 110 may be other radio frequency equipment 110 other than the RRU and comprising the coupler, the first radio frequency device and the second radio frequency device in the embodiments of the present disclosure.

In some embodiments, the radio frequency equipment 110 may further determine, based on the reflection coefficient at the calibration reference plane, a voltage stand wave ratio of the radio frequency equipment 110 at the calibration reference plane during runtime. Based on the method for measuring the voltage stand wave ratio according to the embodiments of the present disclosure, the technical problem that a VSWR measurement system cannot accurately measure the VSWR due to the interference of other unwanted reverse signals and the leakage of unwanted forward signals can be solved.

In some embodiments, in order to determine the reflection coefficient at the measurement reference plane, the radio frequency equipment 110 may perform the flow shown in Fig. 5. According to Fig. 5, a flow 500 for determining the reflection coefficient at the measurement reference plane mainly comprises: at block 502, based on offline calibration data, determining a forward leakage signal leaking from the first radio frequency device to the coupler. At block 504, determining, based on the offline calibration data, a forward insertion loss (denoted as $\overrightarrow{S_{BA}}$) of the coupler. At block 506, determining, based on the forward measurement signal from the first radio frequency device to the second radio frequency device, the reverse measurement signal from the second radio frequency device to the first radio frequency device, the forward leakage signal leaking from the first radio frequency device to the coupler, and the forward insertion loss of the coupler, the reflection coefficient at the measurement reference plane. By the flow of Fig. 5, only one coupler needs to be added in the radio frequency equipment, and the reflection coefficient at the measurement reference plane is determined by using the forward insertion loss of the coupler, thereby not only reducing the hardware cost, but also improving the measurement accuracy of the reflection coefficient.

In some embodiments, in order to determine the forward leakage signal leaking from the first radio frequency device to the coupler, the radio frequency equipment 110 may specifically determine, based on the offline calibration data, a target forward measurement signal and a target forward leakage signal, and determine, based on the forward measurement signal from the first radio frequency device to the second radio frequency device, the target forward measurement signal and the target forward leakage signal, the forward leakage signal. The forward leakage signal is determined by means of the offline calibration data, and since the offline calibration may be completed in the factory phase, batch operations are realized, and the increase in the operation cost is very small.

In some embodiments, in order to determine the forward insertion loss of the coupler, the radio frequency equipment 110 may specifically obtain, from the offline calibration data, the forward insertion loss which is obtained by measuring the coupler by a vector network analyzer.

In some embodiments, the process of determining the reflection coefficient at the calibration reference plane may comprise: determining, based on the offline calibration data, an error parameter set of an error model, wherein the error model represents a reflection coefficient difference between the calibration reference plane and the measurement reference plane; and obtaining, based on the error model and the error parameter set, the reflection coefficient at the calibration reference plane from the reflection coefficient at the measurement reference plane. By means of obtaining the reflection coefficient at the calibration reference plane in the above ways, the measurement accuracy can be better guaranteed.

In some embodiments, before running, the radio frequency equipment 110 may determine the error parameter set by executing an equipment-level calibration process. The error parameter set is determined in an offline calibration phase, which may be completed in the factory, thereby reducing the operation cost.

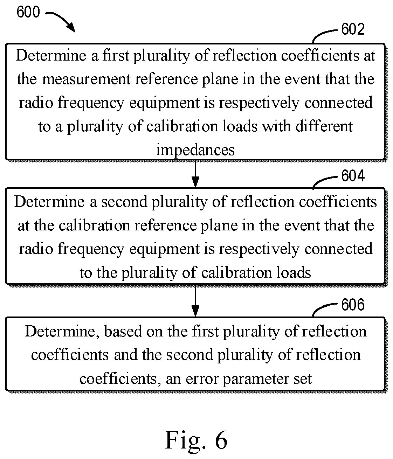

In some embodiments, an equipment-level calibration flow 600 executed by the radio frequency equipment 110 may be shown in Fig. 6. With reference to Fig. 6, the flow 600 comprises: at block 602, determining a first plurality of reflection coefficients at the measurement reference plane when the radio frequency equipment 110 is respectively connected to a plurality of calibration loads 120 with different impedances. At block 604, determining a second plurality of reflection coefficients at the calibration reference plane when the radio frequency equipment 110 is respectively connected to the plurality of calibration loads 120. At block 606, determining, based on the first plurality of reflection coefficients and the second plurality of reflection coefficients, the error parameter set. By means of setting the plurality of calibration loads 120 with different impedances, the error parameter set can be determined by solving an equation set, thereby guaranteeing the accuracy of the error parameter set.

In some embodiments, the radio frequency equipment 110 may determine the second plurality of reflection coefficients by using a vector network analyzer. Specifically, the radio frequency equipment 110 may obtain the second plurality of reflection coefficients, which are obtained by measuring the plurality of calibration loads 120 by the vector network analyzer.

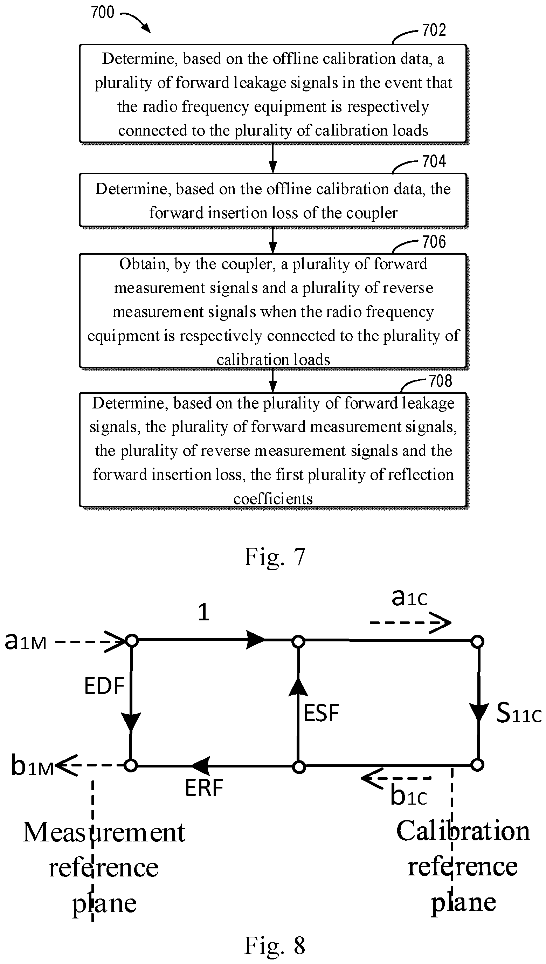

In some embodiments, in order to determine the first plurality of reflection coefficients at the measurement reference plane when the radio frequency equipment 110 is respectively connected to the plurality of calibration loads 120 with different impedances, the radio frequency equipment 110 may execute a flow 700 shown in Fig. 7. With reference to Fig. 7, the flow 700 comprises, at block 702, based on the offline calibration data, determining a plurality of forward leakage signals when the radio frequency equipment 110 is respectively connected to the plurality of calibration loads 120. At block 704, based on the offline calibration data, determining a forward insertion loss of the coupler. At block 706, obtaining, by the coupler, a plurality of forward measurement signals and a plurality of reverse measurement signals when the radio frequency equipment 110 is respectively connected to the plurality of calibration loads 120. At block 708, determining, based on the plurality of forward leakage signals, the plurality of forward measurement signals, the plurality of reverse measurement signals and the forward insertion loss, the first plurality of reflection coefficients. The first plurality of reflection coefficients are determined based on the offline calibration data and the forward insertion loss of the coupler, thereby overcoming the defect that some previous solutions greatly increase the hardware cost, and by means of the method in the embodiments of the present disclosure, the measurement accuracy can be guaranteed.

In some embodiments, during the process of executing the equipment-level calibration process, the radio frequency equipment 110 may further determine, in the case where the radio frequency equipment 110 is connected to a spectrum analyzer, a target transmission gain of the radio frequency equipment 110 based on target output power at the calibration reference plane, and in the case where the radio frequency equipment 110 is respectively connected to the plurality of calibration loads 120, when the radio frequency equipment 110 provides the target transmission gain, the radio frequency equipment 110 may measure the plurality of forward measurement signals and the plurality of reverse measurement signals by using the coupler.

In some embodiments, during the process of executing the equipment-level calibration process, the radio frequency equipment 110 may further determine a target forward measurement signal and a target forward leakage signal based on the offline calibration data, and determine, based on the plurality of forward measurement signals when the radio frequency equipment 110 is respectively connected to the plurality of calibration loads 120, the target forward measurement signal, and the target forward leakage signal, a plurality of forward leakage signals when the radio frequency equipment 110 is respectively connected to the plurality of calibration loads 120 .

In some embodiments, before executing the equipment-level calibration process, the radio frequency equipment 110 may execute a half-box-level calibration process, so as to determine the target forward measurement signal and a target forward leakage signal.

In some embodiments, the half-box-level calibration process executed by the radio frequency equipment 110 may comprise: in the case where the radio frequency equipment 110 in a half-box state provides the target output power at the measurement reference plane, obtaining the target forward measurement signal and the target forward leakage signal by using the coupler, wherein the radio frequency equipment 110 in the half-box state does not include the second radio frequency device.

In some embodiments, during the half-box-level calibration process, the radio frequency equipment 110 may be connected to the spectrum analyzer, the coupler may be respectively connected to a transmission link of the radio frequency equipment 110 and the spectrum analyzer, the target forward measurement signal is a measured signal from the transmission link to the spectrum analyzer, and the target forward leakage signal is a measured signal leaking from the transmission link to the coupler. In the embodiments of the present disclosure, the target forward measurement signal and the target forward leakage signal may be obtained based on the half-box-level calibration process at a lower cost.

In the embodiments of the present disclosure, the offline calibration data may include data determined or obtained by means of measurement or calculation in various offline calibration processes (device-level calibration, half-box-level calibration, equipment-level calibration, and the like) of the radio frequency equipment 110, which may specifically refer to the introduction of various offline calibration processes below.

In order to more clearly illustrate the measurement solution of the embodiments of the present disclosure, an error model caused by the difference between the measurement reference plane and the calibration reference plane in a single-port network is described in detail below.

Fig. 8 illustrates a schematic diagram of an error model according to some embodiments of the present disclosure. As shown in Fig. 8, according to the microwave theory, for the single-port network, the error model due to the difference between the measurement reference plane and the calibration reference plane may be described by a signal flowchart shown in Fig. 8. Correspondingly, a scattering parameter (or referred to as a reflection coefficient) relationship between the measurement reference plane and the calibration reference plane may be expressed as:

$$\ldots\ldots\overrightarrow{S_{11C}} = \frac{(\overrightarrow{S_{11M}} - \overrightarrow{EDF})}{[\overrightarrow{ERF} + (\overrightarrow{S_{11M}} - \overrightarrow{EDF}) * \overrightarrow{ESF}]} \ldots\ldots\ldots\ldots\ldots\ldots\ldots (1)$$

wherein $\overrightarrow{S_{11C}}$ represents a scattering parameter (vector form) of the single-port network on the calibration reference plane. $\overrightarrow{S_{11M}}$ represents a scattering parameter (vector form) of the single-port network on the measurement reference plane. $\overrightarrow{EDF}$ represents an error of direction of forward (vector form). $\overrightarrow{EFR}$ represents an error of reflection tracking of forward (vector form). $\overrightarrow{ESF}$ represents an error of source unmatched of forward (vector form).

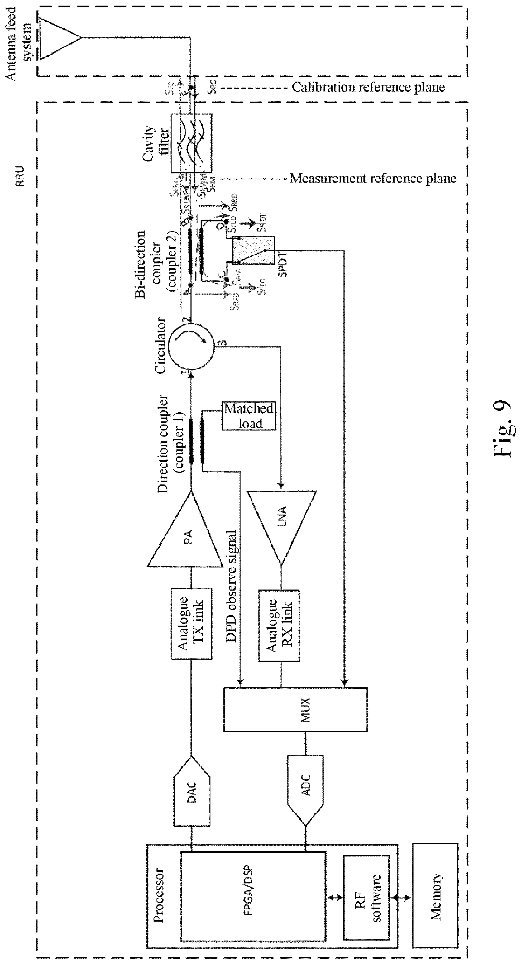

Fig. 9 illustrates a schematic diagram of an overall architecture of VSWR measurement according to some embodiments of the present disclosure. As shown in Fig. 9, in the overall architecture of VSWR measurement in the embodiments of the present disclosure, an independent bi-direction coupler (i.e., a coupler 2) is disposed between the circulator and the cavity filter, so as to measure the VSWR more accurately.

In a processor, a field programmable gate array (FPGA)/digital signal processor (DSP) is to process downlink and uplink digital intermediate frequency signals, including measurement of the amplitude and phase of a received forward or reverse signal. The amplitude and the phase compose a vector signal. How to measure the amplitude and the phase is not described in the embodiments of the present disclosure, and reference may be made to a universal amplitude and phase measurement method. There are two reference planes in Fig. 9: one is a measurement reference plane between the bi-direction coupler (i.e., the coupler 2) and the cavity filter, and the other is a calibration reference plane between the cavity filter and an external antenna feed system. It should be noted that, the offline calibration and runtime measurement (i.e., online measurement) discussed in the embodiments of the present disclosure are applicable to all frequencies within the frequency range of product declaration. In Fig. 9, ADC represents an analog-to-digital converter, DAC represents a digital-to-analog converter, PA represents a power amplifier, and LNA represents a low-noise amplifier.

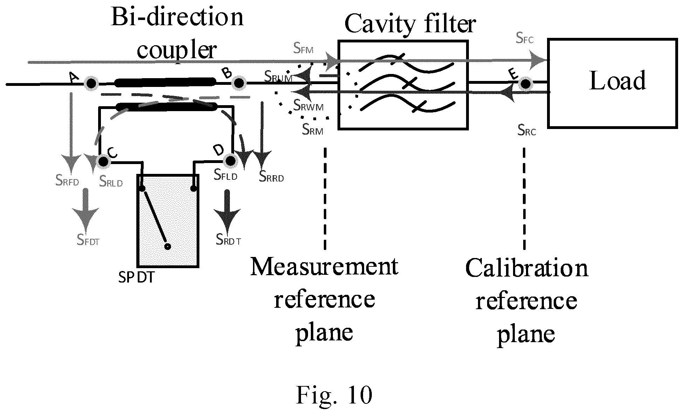

Fig. 10 illustrates a detailed schematic diagram of relevant circuits at the measurement reference plane and the calibration reference plane according to some embodiments of the present disclosure. The detailed schematic diagram is a schematic diagram after a local circuit in Fig. 9 is amplified. A detailed VSWR detection circuit and a relevant signal component as shown in Fig. 10 relate to 12 parameters: $\overrightarrow{s_{FDT}}$, $\overrightarrow{s_{RFD}}$, $\overrightarrow{s_{RLD}}$, $\overrightarrow{S_{RDT}}$, $\overrightarrow{S_{RRD}}$, $\overrightarrow{S_{FLD}}$, $\overrightarrow{S_{RM}}$, $\overrightarrow{S_{RWM}}$, $\overrightarrow{S_{RUM}}$, $\overrightarrow{S_{FM}}$, $\overrightarrow{S_{FC}}$ and $\overrightarrow{S_{RC}}$, and these parameters will be introduced below one by one.

At a forward detection point C, there is a relational expression as follows: $\overrightarrow{s_{FDT}} = \overrightarrow{s_{RFD}} + \overrightarrow{s_{RLD}}$, wherein $\overrightarrow{s_{FDT}}$ represents a total vector signal of forward detection, which is one example of the forward measurement signal from the first radio frequency device to the second radio frequency device. $\overrightarrow{s_{RFD}}$ represents an vector signal of real forward detection, which is one example of the real forward measurement signal from the first radio frequency device to the second radio frequency device. $\overrightarrow{s_{RLD}}$ represents a vector signal of reverse leakage detection, which is one example of the reverse leakage signal leaking from the second radio frequency device to the coupler.

At a reverse detection point D, there is a relational expression as follows: $\overrightarrow{S_{RDT}} = \overrightarrow{S_{RRD}} + \overrightarrow{S_{FLD}}$, wherein $\overrightarrow{S_{RDT}}$ represents a total vector signal of reverse detection, which is one example of the reverse measurement signal from the second radio frequency device to the first radio frequency device. $\overrightarrow{S_{RRD}}$ represents an vector signal of real reverse detection, which is one example of the real reverse measurement signal from the second radio frequency device to the first radio frequency device. $\overrightarrow{S_{FLD}}$ represents a vector signal of forward leakage detection, which is one example of the forward leakage signal leaking from the first radio frequency device to the coupler.

At a point B of on the measurement reference plane, there is a relational expression as follows: $\overrightarrow{s_{RM}} = \overrightarrow{s_{RWM}} + \overrightarrow{s_{RUM}}$, wherein $\overrightarrow{s_{RM}}$ represents a vector signal of reverse at measurement plane, $\overrightarrow{s_{RWM}}$ represents a vector signal of reverse wanted at measurement plane, $\overrightarrow{S_{RUM}}$ represents an vector signal of reverse unwanted at measurement plane, and $\overrightarrow{S_{FM}}$ represents a vector signal of forward at measurement plane.

At a point E on the calibration reference plane, $\overrightarrow{S_{FC}}$ represents a vector signal of forward at calibration plane. $\overrightarrow{S_{RC}}$ represents a vector signal of reverse at calibration plane.

The objective of the embodiments of the present disclosure is to obtain a runtime scattering parameter (S11) of the point E from respective runtime total vector signals ($\overrightarrow{S_{FDT}}$, $\overrightarrow{S_{RDT}}$) of the point C and the point D, so as to realize the runtime VSWR measurement of the point E. The runtime scattering parameter of the point E is: $|\overrightarrow{S_{11}}| = \dfrac{|\overrightarrow{S_{RC}}|}{|\overrightarrow{S_{FC}}|}$, but $|\overrightarrow{S_{RC}}|$ and $|\overrightarrow{S_{FC}}|$ cannot be detected.

In order to determine $\dfrac{|\overrightarrow{S_{RC}}|}{|\overrightarrow{S_{FC}}|}$, a relational expression among $\dfrac{|\overrightarrow{S_{RC}}|}{|\overrightarrow{S_{FC}}|}$, $\overrightarrow{S_{RRD}}$ and $\overrightarrow{s_{RFD}}$ may be determined, and then $|\overrightarrow{S_{11}}|$ is calculated by using $\overrightarrow{S_{RRD}}$ and $\overrightarrow{s_{RFD}}$. How to obtain $\overrightarrow{s_{11M}}$ (i.e., $\overrightarrow{s_{RM}}/\overrightarrow{s_{FM}}$) from individual parameters $\overrightarrow{S_{RRD}}$ and $\overrightarrow{S_{RFD}}$ of the bi-direction coupler in the embodiments of the present disclosure will be introduced below in detail.

In some embodiments, in the VSWR measurement solution of the embodiments of the present disclosure, some variables which affect the measurement algorithm may be ignored, and some variables which facilitate to improve the measurement accuracy must be considered, in this way, not only can the swelling of the algorithm be avoided, but the measurement accuracy can also be improved. Specifically, it is necessary to consider $\overrightarrow{S_{RUM}}$ (an vector signal of reverse unwanted at measurement plane), so as to improve the measurement accuracy. In addition, the leakage from the isolation of SPDT and the leakage from the isolation of MUX may be ignored, and the variables which may be ignored and the variables which must be considered are described in detail below.

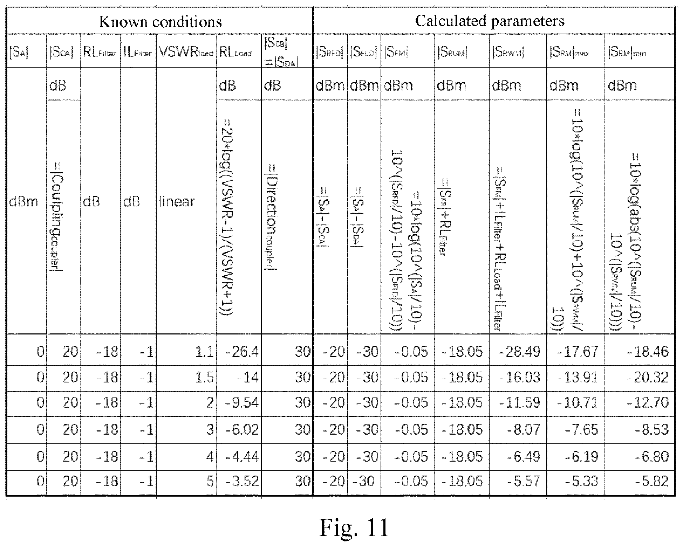

First, it is illustrated why $\overrightarrow{S_{RUM}}$ should be considered for VSWR measurement. A coupling degree (S parameter) is $\overrightarrow{S_{CA}} = \dfrac{\overrightarrow{s_{RFD}}}{\overrightarrow{S_A}}$, and a direction degree (S parameter) is $\overrightarrow{S_{CB}} = \dfrac{\overrightarrow{S_{RLD}}}{\overrightarrow{S_{RM}}}$, wherein $\overrightarrow{s_{RFD}}$ represents the vector signal of real forward detection, $\overrightarrow{s_{RLD}}$ represents the vector signal of reverse leakage detection, and $\overrightarrow{S_{RM}}$ represents the vector signal of reverse at measurement plane. Typical values are set such that $\overrightarrow{S_{CA}}$=20dB and $\overrightarrow{S_{CB}}$=30dB, and $|\overrightarrow{s_A}|$ is set to a normalized power 0dBm. In order to simplify the discussion, relevant parameters may be listed in Fig. 11, and the real result of the discussion is independent with the detailed values of $|\overrightarrow{s_A}|$, which is also a strict profe. Since VSWR=3 and 5 are typical VSWR alarm threshold values, the VSWR range is [1.1, 5]. In Fig. 11, $|\overrightarrow{x}|$ represents the size of $\overrightarrow{x}$, which will not be repeated hereinafter.

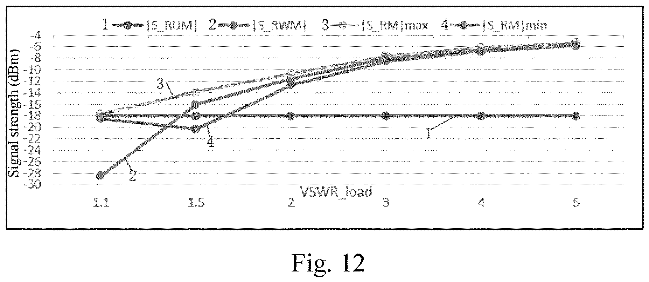

According to table data in Fig. 11, table data of relevant parameters for calculating a reverse signal caused by return losses of the filter and the load 120 according to some embodiments of the present disclosure are shown, and includes two parts, that is, known conditions and calculated parameters. The difference between $|S_{RM}|$ and $|S_{RWM}|$ caused by the return loss (RL) of the cavity filter may be visually compared in Fig. 12. As can be seen from four broken lines (1-4) as shown in Fig. 12, when VSWRLoad<3, the difference is very significant, which may lead to erroneous VSWR calculations and trigger false VSWR alarms.

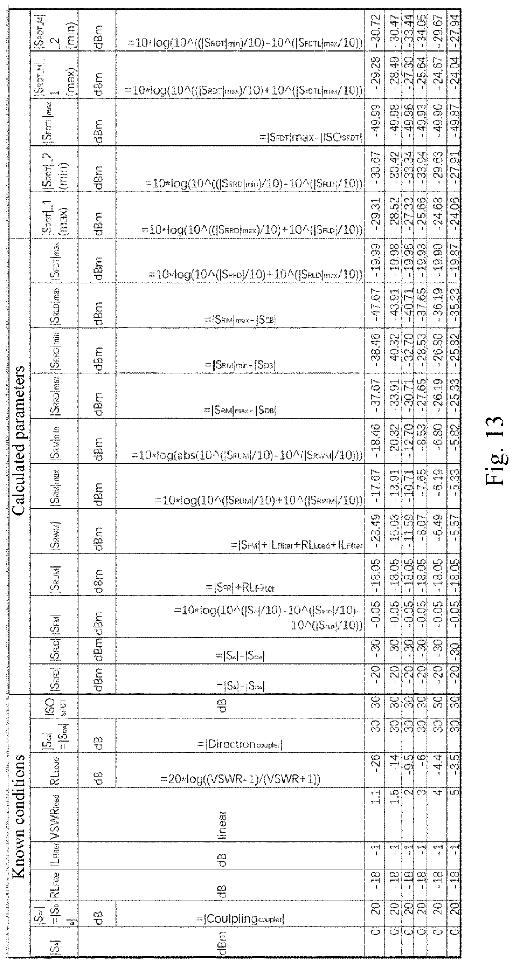

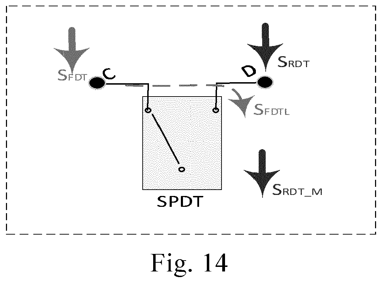

Second, it is illustrated why the leakage from the isolation of SPDT may be ignored. Based on the known conditions in Fig. 11, and according to typical isolation of SPDT 30dB, table data in Fig. 13 may be obtained for evaluating the leakage from the $\overrightarrow{S_{FDT}}$ (the total vector signal of forward detection) to a reverse detection port of SPDT, the leakage signal may be referred to herein as $\overrightarrow{s_{FDTL}}$, the $\overrightarrow{S_{RDT}}$ (the total vector signal of reverse detection) which is measured due to the overlay of $\overrightarrow{s_{FDTL}}$ is referred to as $\overrightarrow{s_{RDT\_M}}$. As shown in Fig. 14, it is a schematic diagram of leakage from a forward port to a reverse port.

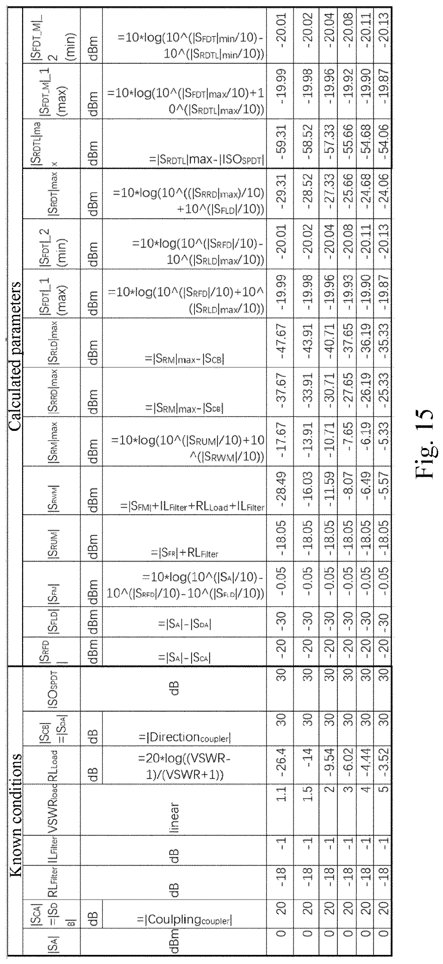

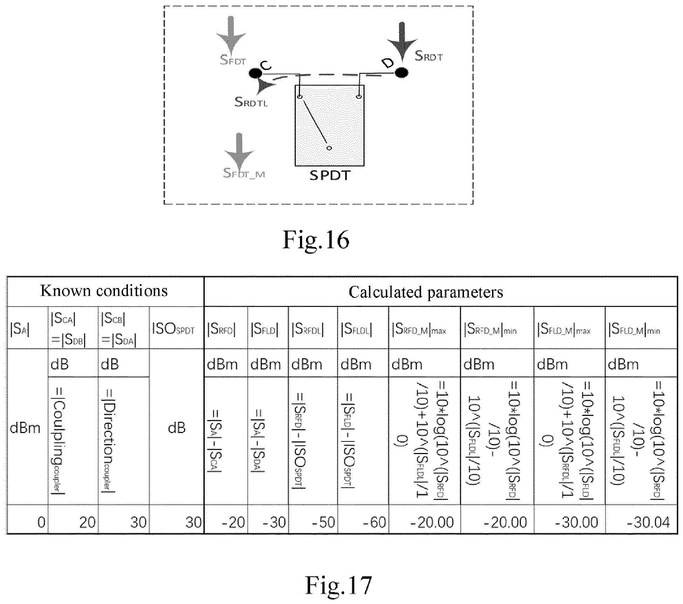

Correspondingly, table data in Fig. 15 may be obtained for evaluating the leakage from $\overrightarrow{S_{RDT}}$ to a forward detection port of SPDT. The leakage signal may be referred to herein as $\overrightarrow{s_{RDTL}}$, and $\overrightarrow{s_{FDT}}$ which is measured due to the overlay of $\overrightarrow{s_{RDTL}}$ is referred to as $\overrightarrow{s_{FDT\_M}}$. As shown in Fig. 16, it is a schematic diagram of leakage from the reverse port to the forward port.

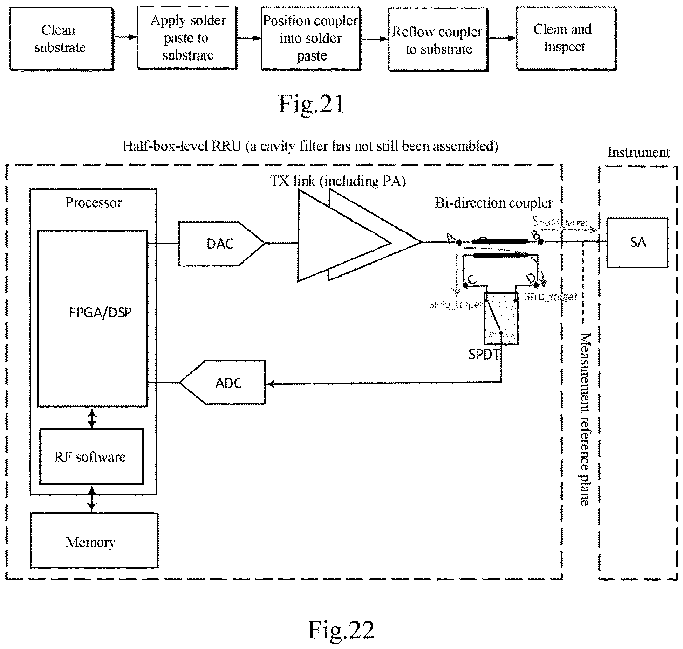

In order to evaluate the influence of the leakage more carefully, the leakage due to the SPDT's isolation in a half-box level is shown in Fig. 22 below. Fig. 17 illustrates a schematic diagram of data used for calculating SPDT leakage in a spectrum analyzer (SA) mode according to some embodiments of the present disclosure, wherein the calculation is a calculation based on the half-box-level SPDT leakage shown in Fig. 22 below.

As can be seen from Fig. 13, Fig. 15 and Fig. 17: $|S_{RDT\_M}|\_1 \approx |S_{RDTL}|\_1$, $|S_{RDT\_M}|\_2 \approx |S_{RDTL}|\_2$, $|S_{FDT\_M}|\_1 = |S_{FDTL}|\_1$, and $|S_{FDT\_M}|\_2 = |S_{FDTL}|\_2$, according to Fig. 17, $|S_{RDT\_M}|max = |S_{RDT\_M}|min = |SRDT|$, and $|S_{FLD\_M}|max = |S_{FLD\_M}|min = |S_{FLD}|$. Thus, the leakage caused by the SPDT isolation may be ignored.

It is illustrated below why the leakage from the isolation of MUX may be ignored. First, a TX (transmission) related signal (DPD (digital pre-distortion), VSWR forward and reverse detection) may be distinguished with a reception (RX) related signal, since there are different frequency ranges for FDD and different time slots for TDD.

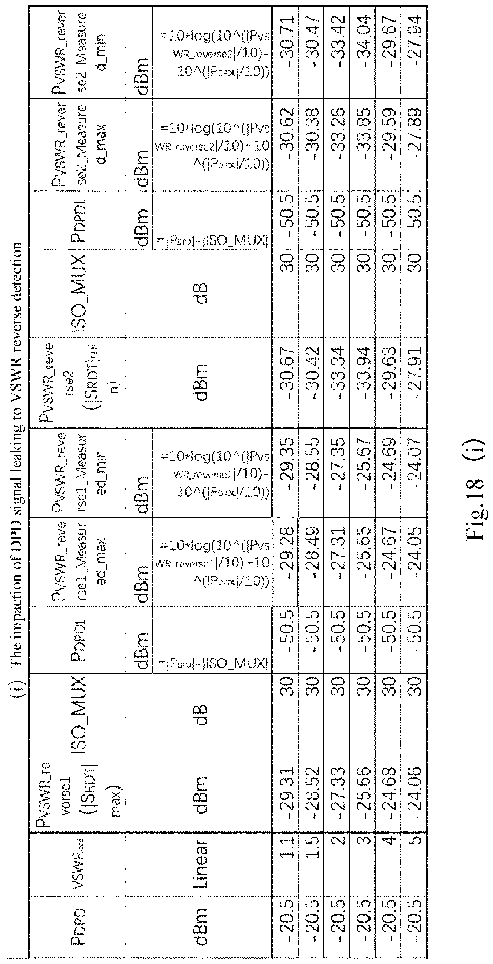

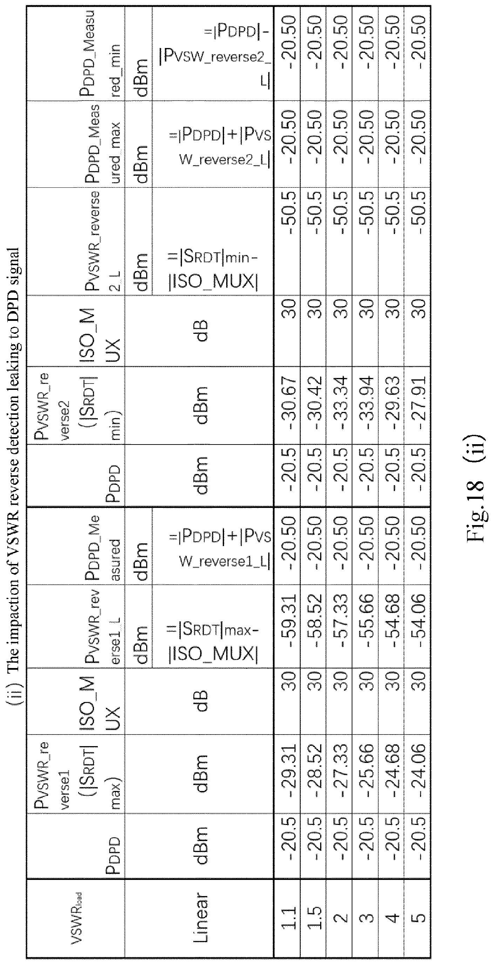

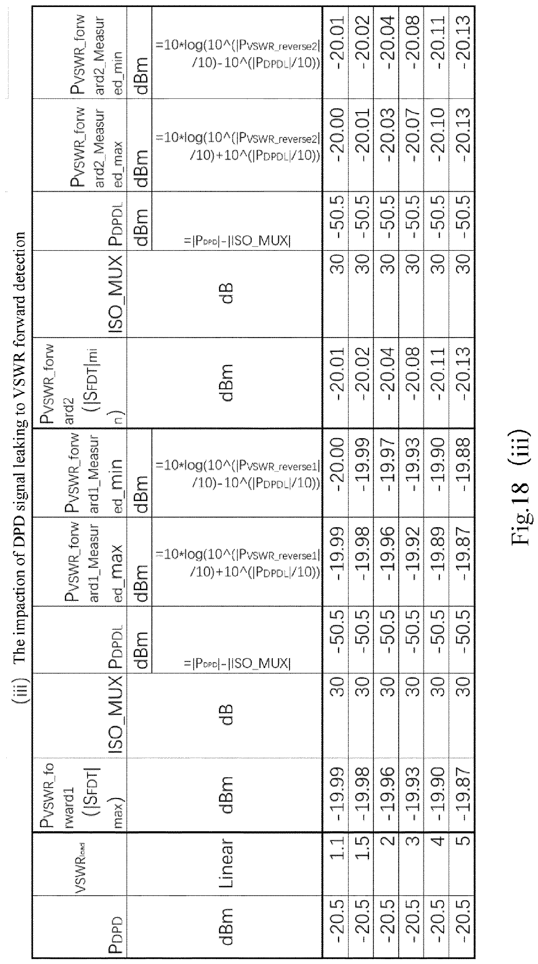

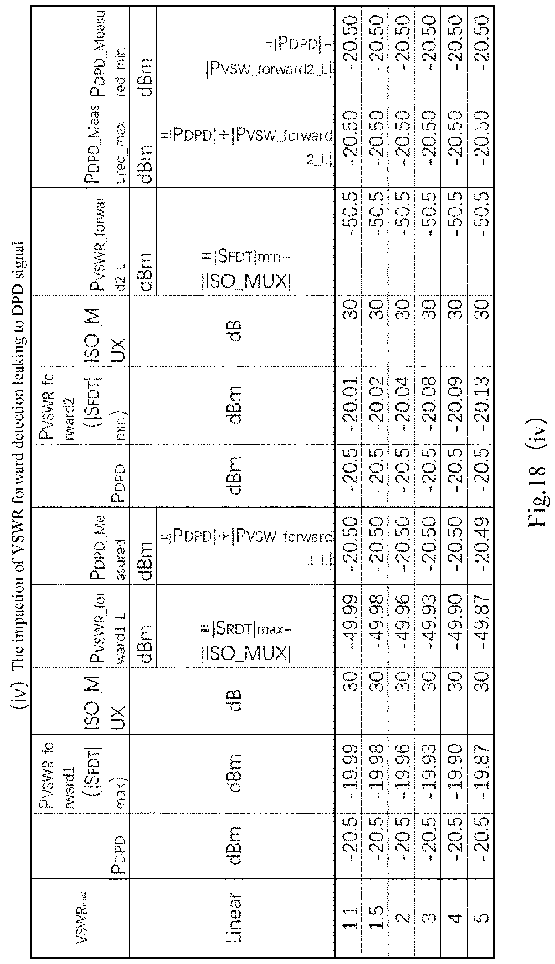

In the embodiments of the present disclosure, the discussion regarding the influence of DPD observe signal leaking to VSWR forward and reverse detection and the influence of VSWR forward and reverse detection leaking to DPD is as follows. The directional degree of the direction coupler is typically about 20dB, and IL of an isolator is about 0.5dB. Fig. 18 (including Fig. 18 (i), Fig. 18 (ii), Fig. 18 (iii) and Fig. 18 (iv)) may be derived from the data |SRDT| and |SFDT| in Fig. 13 and Fig. 15. Fig. 18 (i), Fig. 18 (ii), Fig. 18 (iii) and Fig. 18 (iv) illustrate schematic diagrams of data used for calculating the leakage of an MUX according to some embodiments of the present disclosure. As can be seen from Fig. 18, the leakage of the MUX may be ignored. (The case of the half-box level is similar to that described above, and thus is not listed again).

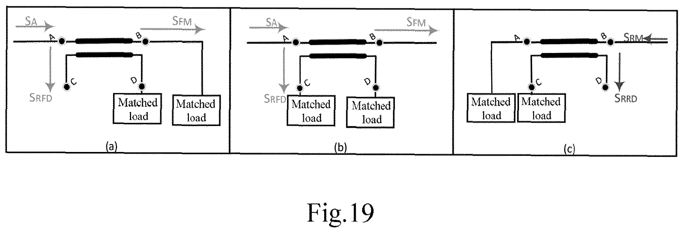

Fig. 19 illustrates a schematic diagram of device-level offline calibration of a bi-direction coupler according to some embodiments of the present disclosure. As shown in Fig. 19, device-level offline calibration data of the bi-direction coupler may be obtained, and the detailed process of determining $\overrightarrow{s_{11M}}$ will be described in detail below in combination with formulas.

In Fig. 19 (a),

$$\ldots\ldots \overrightarrow{S_{CA}} = \frac{\overrightarrow{S_{RFD}}}{\overrightarrow{S_A}} \ldots\ldots\ldots\ldots\ldots\ldots\ldots\ldots\ldots\ldots\ldots\ldots\ldots\ldots\ldots\ldots\ (2)$$

In Fig. 19 (b), a forward insertion loss vector (S parameter) may be expressed as:

$$\ldots\ldots \overrightarrow{S_{BA}} = \frac{\overrightarrow{S_{FM}}}{\overrightarrow{S_A}} \ldots\ldots\ldots\ldots\ldots\ldots\ldots\ldots\ldots\ldots\ldots\ldots\ldots\ldots\ldots\ (3)$$

Then, the following relationship may be obtained:

$$\ldots\ldots \frac{\overrightarrow{S_{RFD}}}{\overrightarrow{S_{FM}}} = \frac{\overrightarrow{S_{CA}}}{\overrightarrow{S_{BA}}} \ldots\ldots\ldots\ldots\ldots\ldots\ldots\ldots\ldots\ldots\ldots\ldots\ldots\ldots\ (4)$$

In Fig. 19 (c), there are the following relationships:

$$\ldots\ldots \overrightarrow{S_{DB}} = \frac{\overrightarrow{S_{RRD}}}{\overrightarrow{S_{RM}}} \ldots\ldots\ldots\ldots\ldots\ldots\ldots\ldots\ldots\ldots\ldots\ldots\ldots\ldots\ (5)$$

Since the bi-direction coupler is a reciprocal network, there are the following relationships:

$$\ldots\ldots \overrightarrow{S_{DB}} = \overrightarrow{S_{CA}} \ldots\ldots\ldots\ldots\ldots\ldots\ldots\ldots\ldots\ldots\ldots\ldots \quad (6)$$

According to formulas (4), (5) and (6), it may be obtained that:

$$\ldots\ldots \frac{\overrightarrow{S_{RM}}}{\overrightarrow{S_{FM}}} = \frac{\overrightarrow{S_{RRD}}}{\overrightarrow{S_{RFD}}} / \overrightarrow{S_{BA}} \ldots\ldots\ldots\ldots\ldots\ldots\ldots\ldots\ldots\ldots\ldots (7)$$

The $\overrightarrow{S_{BA}}$ may be measured at the device level of the bi-direction coupler by means of a VNA (vector network analyzer). There is little discreteness for the bi-direction coupler, so the data of $\overrightarrow{S_{BA}}$ of some typical samples includes amplitude and phase, which may be written into the memories of batch of RRUs for runtime operation and calibration.

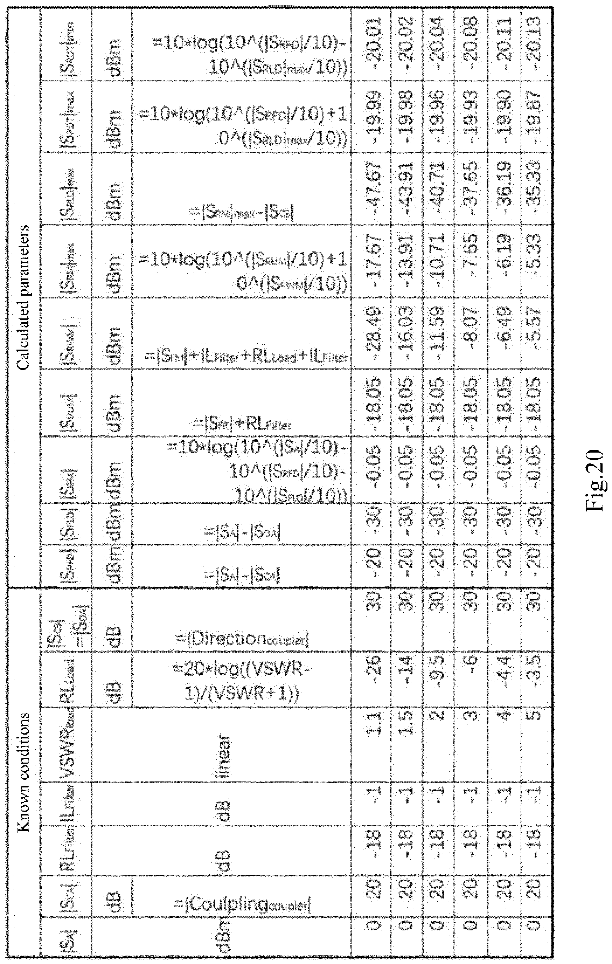

In the above calculation process, $\overrightarrow{s_{RLD}}$ may be ignored. It is illustrated below why $\overrightarrow{s_{RLD}}$ may be ignored. Based on the known conditions shown in Fig. 11, the schematic diagram of data used for calculating a reverse leakage signal of Fig. 20 may be obtained, and it can be seen that $|\overrightarrow{s_{FDT}}| \approx |\overrightarrow{s_{RFD}}|$, so $\overrightarrow{s_{RLD}}$ may be ignored. It should be noted that, if not pointed out, the parameters in all formulas are represented in linear units.

In terms of the feasibility of device-level offline calibration, unlike product-level calibration, the device-level offline calibration may only perform device-level calibration for some samples, so as to get mean/characteristic data, rather than for all samples (little discreteness for batch of couplers). The coupler (specifically, the bi-direction coupler) may be surface mount package from external vender, or may be a microstrip circuit (microstrip/strip line) which is self-designed and is integrated in an RRU's printed circuit board.

In some embodiments, the schematic diagram of surface mounting process steps of the coupler is shown in Fig. 21, including: cleaning a substrate; applying solder paste to substrate; positioning the coupler into the solder paste; reflowing the coupler to the substrate; and cleaning and inspecting.

For the self-designed microstrip circuit, there is no need to ensure the consistency between a test board and the real RRU by means of additional operations. For the coupler provided by the external vender, there is a need to ensure the consistency between the test board and the real RRU. The test board has the same substrate and layout pad as the printed circuit board of the real RRU, and the IL (required calibration data) of the coupler, which has been soldered on the printed circuit board, may be obtained by means of the test board.

Ensuring the consistency between the test board and the real RRU may include: completely the same layout, the same substrate, the same layout pad, the same 50Ω microstrip/strip line, the same reflow soldering process to control the consistency of SMT (surface mounting technology), the same solder paste, the same stencils or syringe dispensers to apply solder paste, the same reflow method, etc.

By means of the above process, device-level calibration data may be obtained and is consistent with the calibration data of the RRU.

Fig. 22 illustrates a schematic diagram of half-box-level offline calibration according to some embodiments of the present disclosure. The half-box-level offline calibration is offline calibration executed by the radio frequency equipment 110 in a half-box state, and at this time, the radio frequency equipment 110 is not assembled with the cavity filter. As shown in Fig. 22, when $P_{outM\_target} = P_{outC\_target} - IL_{Filter\_t}$, wherein $P_{outM\_target}$ represents the target output power (dBm) at the measurement reference plane, $P_{outC\_target}$ represents the target output power (dBm) at the calibration reference plane, and $IL_{Filter\_t}$ represents a typical insertion loss (IL) (dB) of the cavity filter, for example, 1dB.

It may be obtained from the processor that:

$$\ldots\ldots \overrightarrow{S_{RFD\_target}} = A_{RFD\_target} * \exp(j\varphi_{RFD\_target}) \ldots\ldots (8)$$

$$\ldots\ldots \overrightarrow{S_{FLD\_target}} = A_{FLD\_target} * \exp(j\varphi_{FLD\_target}) \ldots\ldots (9)$$

wherein $A_{RFD\_target}$ represents the amplitude (dBm) of $\overrightarrow{S_{RFD\_target}}$, $\varphi_{RFD\_target}$ represents the phase of $\overrightarrow{S_{RFD\_target}}$, $A_{FLD\_target}$ represents the amplitude of $\overrightarrow{S_{FLD\_target}}$, and $\varphi_{FLD\_target}$ represents the phase of $\overrightarrow{S_{FLD\_target}}$. $\overrightarrow{S_{RFD\_target}}$ is one example of a real signal from a transmission link to a spectrum analyzer. In some embodiments, the half-box state is a state in which the cavity filter is not assembled in the radio frequency device. $\overrightarrow{S_{FLD\_target}}$ is one example of the target forward leakage signal, that is, the measured signal from the transmission link to the spectrum analyzer may be used as a real signal from the transmission link to the spectrum analyzer, that is, $\overrightarrow{S_{RFD\_target}}$ may be regarded as the target forward measurement signal.

Due to the discreteness of cavity filter samples, there may be a little fluctuation between the typical IL and the actual IL per sample of the cavity filter. In this case, the actual IL per sample of the cavity filter is set as $IL_{Filter\_a}$, then it may be obtained that:

$$\overrightarrow{S_{RFD\_target\_a}} = (A_{RFD\_target} + IL_{Filter\_a} - IL_{Filter\_t}) * \exp(j\varphi_{RFD\_target}) \quad \ldots\ldots$$

(10)

$$\overrightarrow{S_{FLD\_target\_a}} = (A_{FLD\_target} + IL_{Filter\_a} - IL_{Filter\_t}) * \exp(j\varphi_{FLD\_target}) \quad \ldots\ldots$$

(11)

wherein $\overrightarrow{S_{RFD\_target\_a}}$ represents a vector signal of real forward detection with the target output power at the calibration plane considering the actual IL of the cavity filter, and $\overrightarrow{S_{FLD\_target\_a}}$ represents the vector signal of forward leakage detection with the target output power at the calibration plane considering the actual II, of the cavity filter.

From formulas (10) and (11), it is obtained that:

$$\frac{\overrightarrow{S_{FLD\_target\_a}}}{\overrightarrow{S_{RFD\_target\_a}}} = (A_{FLD_{target}} - A_{RFD\_target}) * \exp[j(\varphi_{FLD\_target} - \varphi_{RFD\_target})]\ldots \quad (12)$$

From equations (10) to (12), it can be seen that the vector value $\dfrac{\overrightarrow{S_{FLD\_target\_a}}}{\overrightarrow{S_{RFD\_target\_a}}}$ is independent of detailed values of $IL_{Filter\_t}$ and $IL_{Filter\_a}$. Here, $IL_{Filter\_t}$ is used as a certain typical value (for example, 1 dB), only in order to enable the transmission (TX) link of a half-box-level RRU to run in a normal state.

It has been introduced above that $\overrightarrow{S_{RFD}}$ represents the vector signal of real forward detection, then, $\overrightarrow{S_{RFD\_runtime}}$ represents a runtime vector signal of real forward detection. When $\overrightarrow{S_{RFD}}$ is $\overrightarrow{S_{RFD\_runtime}}$, the runtime vector signal of real forward detection measured by the processor is:

$$\overrightarrow{S_{RFD\_runtime}} = A_{RFD\_runtime} * \exp(j\varphi_{RFD\_runtime})\ldots\ldots(13)$$

wherein, $A_{RFD\_runtime}$ represents the amplitude (dBm) of $\overrightarrow{S_{RFD\_runtime}}$, and $\varphi_{RFD\_runtime}$ represents the phase of $\overrightarrow{S_{RFD\_runtime}}$.

For a 4-port passive network has the following relationship:

$$\ldots\ldots \frac{\overrightarrow{S_{FLD\_runtime}}}{\overrightarrow{S_{RFD\_runtime}}} = \frac{\overrightarrow{S_{FLD\_target\_a}}}{\overrightarrow{S_{RFD\_target\_a}}}\ldots\ldots\ldots\ldots(13.1)$$

wherein, $\overrightarrow{S_{FLD\_runtime}}$ represents a runtime vector signal of forward leakage detection.

From formula (12), formula (13) and formula (13.1), it may be obtained that:

$$\overrightarrow{S_{FLD\_runtime}} = (A_{FLD\_target} - A_{RFD\_target} + A_{RFD\_runtime}) *$$

$$\exp[j(\varphi_{FLD\_target} - \varphi_{RFD\_target} + \varphi_{RFD\_runtime})]\ldots(14)$$

Only two parameters need to be measured in the half-box-level offline calibration, that is, $\overrightarrow{S_{RFD\_target}}$ and $\overrightarrow{S_{FLD\_target}}$, the measurement may be performed together with the measurement of other TX (transmission) parameters (e.g., TX output power). However, the latter is an operation which needs to be performed in a factory test phase, therefore, the half-box-level offline calibration in the embodiments of the present disclosure does not increase more steps.

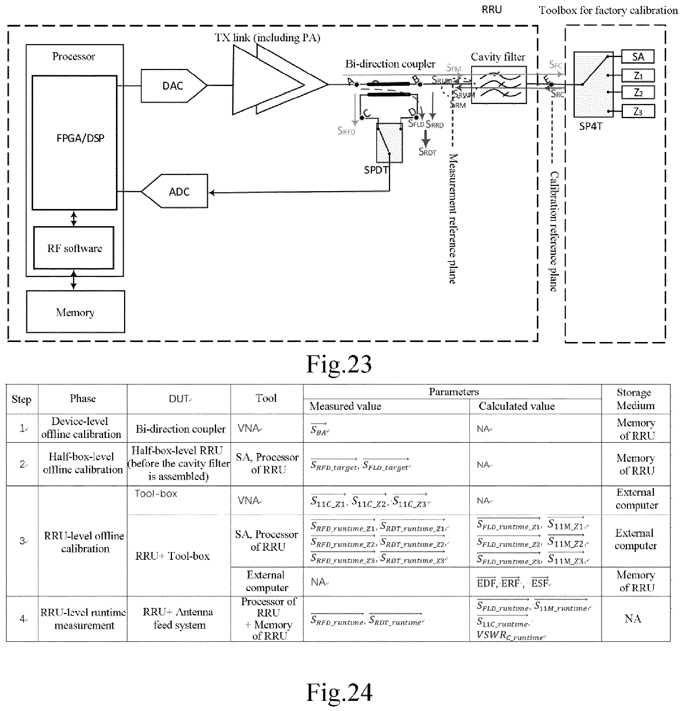

Fig. 23 illustrates a schematic diagram of RRU-level offline calibration according to some embodiments of the present disclosure. As shown in Fig. 23, a tool box (i.e., a tool box for factory calibration in Fig. 23) consists of an SP4T (a single-pole four-throw switch), an SA (Signal Analyzer), and three loads 120 with different impedances (Z1, Z2 and Z3 may be used as examples of a plurality of calibration loads 120). It should be noted that, the toolbox in the embodiments of the present disclosure does not belong to a RRU product, and is only used for efficient factory production. Three different loads 120 may be short-circuit loads, open-circuit loads and standard matched (50Ω) loads, but are not limited to these loads 120. Before connected to the RRU, S11 of a point E of the tool box should be measured, so as to obtain real S parameters: $\overrightarrow{S_{11C\_Z1}}$, and $\overrightarrow{S_{11C\_Z3}}$ (which are specific examples of the second plurality of reflection coefficients). Details of relevant circuits at the measurement reference plane and the calibration reference plane in Fig. 23 may refer to Fig. 10.

A TX gain (including digital and analogue parts) is configured, to make $|\overrightarrow{S_{FC}}|$ = $P_{outC\_target}$, then relationship data between $\overrightarrow{S_{RFD\_target}}$ and the TX gain (a target value) is recorded into the memory. Then, by using the TX gain as the target value (the target value of theTX gain is a specific example of the target transmission gain), the SP4T is switched to $Z_1$, $\overrightarrow{S_{RFD\_runtime}}$ and $\overrightarrow{S_{RDT\_runtime}}$ are recorded, and $\overrightarrow{S_{RDT}}$ represents the total vector signal of reverse detection, and then correspondingly, $\overrightarrow{S_{RDT\_runtime}}$ represents a total vector signal of runtime reverse detection. According to formula (14), $\overrightarrow{S_{FLD\_runtime}}$ may be obtained. Therefore, it may be obtained that:

$$\cdots\cdots\overrightarrow{S_{RRD\_runtime}} = \overrightarrow{S_{RDT\_runtime}} - \overrightarrow{S_{FLD\_runtime}}\cdots\cdots\cdots\cdots(15)$$

Then, according to formula (7), a runtime S parameter at the measurement reference plane may be gotten:

$$\overrightarrow{S_{11M\_runtime}} = \frac{\overrightarrow{S_{RRD\_runtime}}}{\overrightarrow{S_{RFD\_runtime}}*\overrightarrow{S_{BA}}} = \frac{\overrightarrow{S_{RDT\_runtime}} - \overrightarrow{S_{FLD\_runtime}}}{\overrightarrow{S_{RFD\_runtime}}*\overrightarrow{S_{BA}}}\cdots\cdots(16)$$

Therefore, $\overrightarrow{S_{11M\_Z1}}$, $\overrightarrow{S_{11M\_Z2}}$ and $\overrightarrow{S_{11M\_Z3}}$ (specific examples of the first plurality of reflection coefficients) may be calculated correspondingly in an external computer according to formula (16). Specifically, that is, in the event that the radio frequency equipment 110 (which is a RRU in the present example) is respectively connected to a plurality of calibration loads (Z1, Z2, Z3) 120, the obtained $\overrightarrow{S_{RFD}}$ values respectively corresponding to Z1, Z2 and Z3 may be used as examples of a plurality of forward measurement signals. It should be noted that, since $\overrightarrow{S_{RLD}}$ is ignored, the measured forward measurement signal and the real forward measurement signal may be considered to be the same. Correspondingly, in the event that the RRU is respectively connected to the plurality of calibration loads (Z1, Z2, Z3) 120, the obtained $\overrightarrow{S_{RDT}}$ values respectively corresponding to Z1, Z2 and Z3 may be used as examples of the plurality of reverse measurement signals. In the event that the RRU is respectively connected to a plurality of calibration loads (Z1, Z2, Z3) 120, the obtained $\overrightarrow{S_{FLD}}$ values respectively corresponding to Z1, Z2 and Z3 may be used as examples of a plurality of forward leakage signals when the radio frequency equipment 110 is respectively connected to the plurality of calibration loads 120.

From the following equation set (17), $\overrightarrow{EDF}$, $\overrightarrow{ERF}$ and $\overrightarrow{ESF}$ may be solved and are saved in the memory. $\overrightarrow{EDF}$, $\overrightarrow{ERF}$ and $\overrightarrow{ESF}$ are specific examples of an error parameter set of the error model. It should be noted that, all parameters in formula (17), formula (18) and formula (19) are not in logarithm units, but in linear units.

$$\begin{cases} \overrightarrow{S_{11C\_Z1}} = \dfrac{(\overrightarrow{S_{11M\_Z1}} - \overrightarrow{EDF})}{[\overrightarrow{ERF} + (\overrightarrow{S_{11M\_Z1}} - \overrightarrow{EDF}) * \overrightarrow{ESF}]} \\[4mm] \overrightarrow{S_{11C\_Z2}} = \dfrac{(\overrightarrow{S_{11M\_Z2}} - \overrightarrow{EDF})}{[\overrightarrow{ERF} + (\overrightarrow{S_{11M\_Z2}} - \overrightarrow{EDF}) * \overrightarrow{ESF}]} \\[4mm] \overrightarrow{S_{11C\_Z3}} = \dfrac{(\overrightarrow{S_{11M\_Z3}} - \overrightarrow{EDF})}{[\overrightarrow{ERF} + (\overrightarrow{S_{11M\_Z3}} - \overrightarrow{EDF}) * \overrightarrow{ESF}]} \end{cases} \quad \dots\dots(17)$$

$\dots\dots$

The RRU-level calibration may specifically be subdivided into two subphases, one subphase is tool box calibration, where the tool box may be considered as other tools, which means that this subphase only needs to be executed once before mass production. For example, after the subphase is done, for special samples A/B.C..., this subphase won't be done any more. No more obvious work for this subphase. The other subphase is "RRU + tool box" level calibration, and $\overrightarrow{EDF}$, $\overrightarrow{ERF}$ and $\overrightarrow{ESF}$ are obtained in this subphase. In terms of automated testing and computing power, in fact, the algorithm proposed in the embodiments of the present disclosure is simple, and the production process is clear and easy to be executed. The RRU-level offline calibration phase is a specific example of the equipment-level calibration process.

It should be noted that in the embodiments of the present disclosure, the tool box used in the RRU-level offline calibration phase may be used for the production of all batches of RRUs, and the SA (signal analyzer), such as a spectrum analyzer, is the most expensive component in the tool box, which is essential to typical factory manufacturing, and thus the cost expenditure increased by using the tool box in the embodiments of the present disclosure is insignificant.

The phase of online runtime measurement (i.e., RRU-level runtime measurement) will be introduced below, and this phase is implemented based on the schematic diagram of Fig. 9. Continuing to refer to Fig. 9, according to formulas (16) and (14), $\overrightarrow{S_{11M\_runtime}}$ may be calculated. Therefore, with reference to the error model shown in Fig. 8, it may be obtained that:

$$\dots\dots\overrightarrow{S_{11C\_runtime}} = \frac{(\overrightarrow{S_{11M\_runtime}} - \overrightarrow{EDF})}{[\overrightarrow{ERF} + (\overrightarrow{S_{11M\_runtime}} - \overrightarrow{EDF}) * \overrightarrow{ESF}]}\dots\dots\dots(18)$$

Therefore, the VSWR at the calibration reference plane (a connection point between the RRU and the antenna feed system) may be calculated by the following formula:

$$\dots\dots VSWR_{C\_runtime} = \frac{1 + |\overrightarrow{S_{11C\_runtime}}|}{1 - |\overrightarrow{S_{11C\_runtime}}|}\dots\dots\dots\dots(19)$$

By means of the above introduction and with reference to Fig. 9, it can be seen that the measurement of the voltage stand wave ratio in the embodiments of the present disclosure may be mainly divided into four steps, that is: device-level offline calibration; half-box-level offline calibration; RRU-level offline calibration; and RRU-level runtime measurement.

Fig. 24 illustrates a schematic diagram of VSWR calibration and measurement.

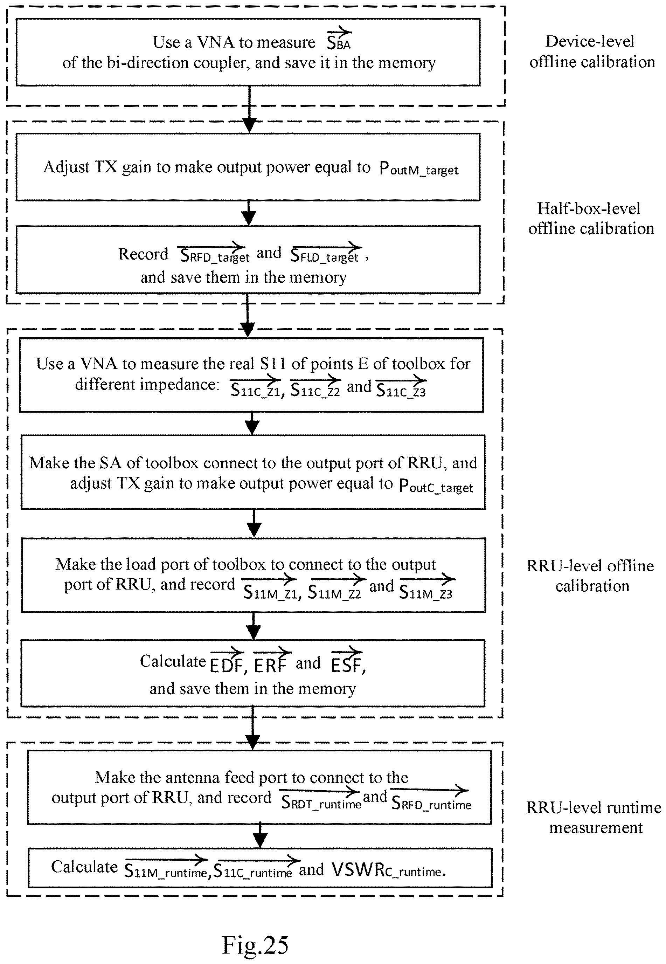

Fig. 25 illustrates a schematic diagram of a measurement flow of a voltage stand wave ratio according to some embodiments of the present disclosure. As shown in Fig. 25, the measurement flow may include: in the device-level offline calibration phase, using a VNA to measure $\overrightarrow{S_{BA}}$ (a forward insertion loss vector) of the bi-direction coupler, and saving it in the memory; in the half-box-level offline calibration phase, adjusting the TX gain (transmission gain) to make the output power equal to $P_{outM\_target}$ (the target output power (dBm) at the measurement reference plane), recording $\overrightarrow{S_{RFD\_target}}$ (which represents the vector signal of real forward detection corresponding to the half-box-level offline calibration phase) and $\overrightarrow{S_{FLD\_target}}$ (which represents the vector signal of forward leakage detection corresponding to the half-box-level offline calibration phase), and saving them in the memory; in the RRU-level offline calibration phase, using a VNA to measure the real S11 of the points E of toolbox for different impedances: $\overrightarrow{S_{11C\_Z1}}$, $\overrightarrow{S_{11C\_Z2}}$ and $\overrightarrow{S_{11C\_Z3}}$. Making

the SA of the tool box connect to the output port of the RRU, and adjusting the TX gain to make the output power equal to $P_{outC\_target}$ (which represents the target output power (dBm) at the calibration reference plane), then making the load port of the tool box to connect to the output port of the RRU, and recording S parameters $\overrightarrow{S_{11M\_Z1}}$, $\overrightarrow{S_{11M\_Z2}}$ and $\overrightarrow{S_{11M\_Z3}}$ of the measurement reference plane respectively corresponding to the impedances Z1, Z2 and Z3, and finally solving the equation set (e.g., formula (17)) to obtain $\overrightarrow{EDF}$, $\overrightarrow{ERF}$ and $\overrightarrow{ESF}$, and saving them in the memory; and in the RRU-level runtime measurement phase, making the antenna feed port to connect to the output port of the RRU, and recording $\overrightarrow{S_{RFD\_runtime}}$ (which represents a variable of the RRU-level runtime measurement phase corresponding to $\overrightarrow{S_{RFD}}$, and $\overrightarrow{S_{RFD}}$ represents the vector signal of real forward detection) and $\overrightarrow{S_{RDT\_runtime}}$ (which represents a variable of the RRU-level runtime measurement phase corresponding to $\overrightarrow{S_{RDT}}$, and $\overrightarrow{S_{RDT}}$ represents the total vector signal of reverse detection), calculating $\overrightarrow{S_{11M\_runtime}}$ (which corresponds to the variable of the S parameter $\overrightarrow{S_{11M}}$ during RRU-level runtime) and $\overrightarrow{S_{11C\_runtime}}$ (which corresponds to the S parameter $\overrightarrow{S_{11C}}$ during RRU-level runtime), and then calculating, based on formula (18) and formula (19), $VSWR_{C\_runtime}$ (the VSWR at the calibration reference plane (the connection point between the RRU and the antenna feed system)).

Compared with the exsiting measurement solution, the VSWR measurement method in the embodiments of the present disclosure does not need to add many devices, but only needs to add one bi-direction coupler, so that the increased cost is insignificant for the cost increase of the RRU, and thus low-cost VSWR measurement can be realized. Moreover, the measurement method in the embodiments of the present disclosure does not require a complex matrix calculation or search algorithm, and thus is easy to to be implemented. In addition, due to very simple runtime measurement process, low CPU resource consumption and quick report period for runtime measurement can be reached. In terms of measurement accuracy, runtime traffic/power fluctuation may be compatible, and not only can forward leakage interference be corrected, but also reverse unwanted interference can be corrected.

In some example embodiments, an apparatus capable of performing the method 400 may comprise means for executing respective steps of the method 400. The means may be implemented in any suitable form. For example, the components may be implemented in a circuit or software module.

In some example embodiments, the apparatus may comprise: means for, during runtime of a radio frequency equipment 110, obtaining, by a coupler in the radio frequency equipment 110, a forward measurement signal from a first radio frequency device to a second radio frequency device of the radio frequency equipment 110 and a reverse measurement signal from the second radio frequency device to the first radio frequency device; means for determining, based on the forward measurement signal, the reverse measurement signal and offline calibration data, a reflection coefficient at a measurement reference plane between the coupler and the second radio frequency device; and means for determining, based on the reflection coefficient at the measurement reference plane, a reflection coefficient at a calibration reference plane between the second radio frequency device and a load 120 of the radio frequency equipment 110.

In some embodiments, the apparatus may further comprise means for determining, based on the reflection coefficient at the calibration reference plane, a voltage stand wave ratio at the calibration reference plane during the runtime of the radio frequency equipment 110.

In some embodiments, the means for determining the reflection coefficient at the measurement reference plane between the coupler and the second radio frequency device may further comprise: means for determining, based on the offline calibration data, a forward leakage signal leaked from the first radio frequency device to the coupler; means for determining, based on the offline calibration data, a forward insertion loss of the coupler; and means for determining, based on the forward measurement signal, the reverse measurement signal, the forward leakage signal and the forward insertion loss, the reflection coefficient at the measurement reference plane.

In some embodiments, the means for determining the forward leakage signal may further comprise: means for determining, based on the offline calibration data, a target forward measurement signal and a target forward leakage signal; and means for determining, based on the forward measurement signal, the target forward measurement signal and the target forward leakage signal, the forward leakage signal.

In some embodiments, the means for determining the forward insertion loss of the coupler may further comprise: means for obtaining, from the offline calibration data, the forward insertion loss obtained by measuring the coupler by a vector network analyzer.

In some embodiments, the means for determining the reflection coefficient at the calibration reference plane between the second radio frequency device and the load 120 of the radio frequency equipment 110 may further comprises: means for determining, based on the offline calibration data, an error parameter set of an error model; and means for obtaining, based on the error model and the error parameter set, the reflection coefficient at the calibration reference plane from the reflection coefficient at the measurement reference plane, wherein the error model represents a reflection coefficient difference between the calibration reference plane and the measurement reference plane.

In some embodiments, the means for determining the error parameter set of the error model may further comprise: means for, prior to a running of the radio frequency equipment 110, executing an equipment-level calibration process to determine the error parameter set.

In some embodiments, the apparatus may further comprise means for determining a first plurality of reflection coefficients at the measurement reference plane in the event that the radio frequency equipment 110 is respectively connected to a plurality of calibration loads 120 with different impedances. The apparatus may further comprise means for determining a second plurality of reflection coefficients at the calibration reference plane in the event that the radio frequency equipment 110 is respectively connected to the plurality of calibration loads 120. The means for determining the error parameter set of the error model may further comprise: means for determining, based on the first plurality of reflection coefficients and the second plurality of reflection coefficients, the error parameter set.

In some embodiments, the means for determining the second plurality of reflection coefficients at the calibration reference plane in the event that the radio frequency equipment 110 is respectively connected to the plurality of calibration loads 120 may further comprise: means for obtaining the second plurality of reflection coefficients obtained by measuring the plurality of calibration loads 120 by a the vector network analyzer.

In some embodiments, the apparatus may further comprise means for determining, based on the offline calibration data, a plurality of forward leakage signals in the event that the radio frequency equipment 110 is respectively connected to the plurality of calibration loads 120. The means for determining the forward insertion loss of the coupler may further comprise means for determining, based on the offline calibration data, the forward insertion loss of the coupler. The apparatus may further comprise means for obtaining, by the coupler, a plurality of forward measurement signals and a plurality of reverse measurement signals when the radio frequency equipment 110 is respectively connected to the plurality of calibration loads 120. The means for determining the plurality of first reflection coefficients at the measurement reference plane in the event that the radio frequency equipment 110 is respectively connected to the plurality of calibration loads 120 with different impedances further comprises: means for determining, based on the plurality of forward leakage signals, the plurality of forward measurement signals, the plurality of reverse measurement signals and the forward insertion loss, the plurality of first reflection coefficient.

In some embodiments, the apparatus may further comprise means for, in the event that the radio frequency equipment 110 is connected to a spectrum analyzer, determining, based on a target output power at the calibration reference plane, a target transmission gain of the radio frequency equipment 110. The means for obtaining, by the coupler, the plurality of forward measurement signals and the plurality of reverse measurement signals when the radio frequency equipment 110 is respectively connected to the plurality of calibration loads 120 further comprises: means for, in the event that the radio frequency equipment 110 is respectively connected to the plurality of calibration loads 120, upon the radio frequency equipment 110 provides the target transmission gain, using the coupler to measure the plurality of forward measurement signals and the plurality of reverse measurement signals.

In some embodiments, the means for determining, based on the offline calibration data, the plurality of forward leakage signals when the radio frequency equipment 110 is respectively connected to the plurality of calibration loads 120 may further comprises: means for determining a target forward measurement signal and a target forward leakage signal based on the offline calibration data; and means for determining, based on the plurality of forward measurement signals, the target forward measurement signal and the target forward leakage signal, the plurality of forward leakage signals.

In some embodiments, the means for determining the target forward measurement signal and the target forward leakage signal based on the offline calibration data may further comprise: means for, prior to the equipment-level calibration process, executing a half-box-level calibration process, to determine the target forward measurement signal and the target forward leakage signal.

In some embodiments, the means for determining the target forward measurement signal and the target forward leakage signal based on the offline calibration data may further comprise: means for, in the event that the radio frequency equipment 110 in a half-box state provides the target output power at the measurement reference plane, using the coupler to obtain the target forward measurement signal and the target forward leakage signal, wherein the radio frequency equipment 110 in the half-box state does not comprise the second radio frequency device.

In some embodiments, during the half-box-level calibration process of the apparatus, the radio frequency equipment 110 is connected to the spectrum analyzer, the coupler is respectively connected to the transmission link of the radio frequency equipment 110 and the spectrum analyzer, the target forward measurement signal is a measured signal from the transmission link to the spectrum analyzer, and the target forward leakage signal is a measured signal leaking from the transmission link to the coupler.

In some embodiments, the radio frequency equipment 110 is a remote radio unit (RRU), the coupler is a bi-direction coupler, the first radio frequency device is a circulator, the second radio frequency device is a cavity filter, and the load 120 is an antenna feed system.

In some embodiments, the apparatus further comprise means for performing other steps in some embodiments of the method 400. In some embodiments, the means comprises at least one processor, and at least one memory including computer program code, the at least one memory and the computer program code configured to, with the at least one processor, cause the performance of the apparatus.

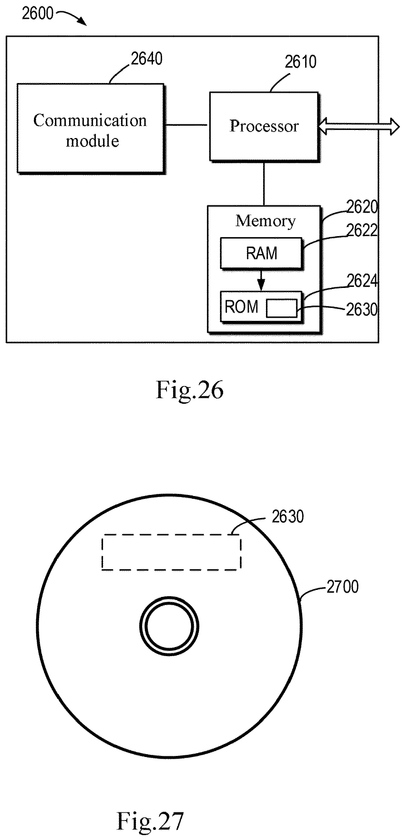

Fig. 26 is a simplified block diagram of an electronic equipment 2600 that is suitable for implementing embodiments of the present disclosure. The equipment 2600 may be provided to implement the radio frequency equipment 110. As shown in the figure, the equipment 2600 includes one or more processors 2610, one or more memories 2620 coupled to the processor 2610, and a communication module 2640 is coupled to the processor 2610.

The communication module 2640 is, for example, a transmission link, and the transmission link is a radio frequency circuit. The processor 2610 may be of any type suitable for a local technology network and may include, but is not limited to, a general-purpose computer, a special-purpose computer, a micro-controller, a digital signal controller (DSP), and one or more of controller-based multi-core controller architectures. The equipment 2600 may have a plurality of processors, such as an application-specific integrated circuit chip that is slaved in time to a clock which synchronizes the main processor.

The memory 2620 may include one or more non-volatile memories and one or more volatile memories. Examples of the non-volatile memories include, but are not limited to, a read-only memory (ROM) 2624, an erasable programmable read-only memory (EPROM), a flash memory, a hard disk, a compact disk (CD), a digital video disk (DVD), and other magnetic storage and/or optical storage. Examples of the volatile memories include, but are not limited to, a random access memory (RAM) 2622 and other volatile memories which do not last in a power-off duration.

A computer program 2630 includes computer-executable instructions executed by the associated processor 2610. The program 2630 may be stored in the ROM 2620. The processor 2610 may load the program 2630 into the RAM 2620, so as to execute any suitable action and processing.

The embodiments of the present disclosure may be implemented by means of the program 2630, so that the equipment 2600 may perform any process of the present disclosure as discussed with reference to Figs. 4 to 25. The embodiments of the present disclosure may also be implemented by hardware or by a combination of software and hardware.

In some embodiments, the program 2630 may be tangibly contained in a computer-readable medium, and the computer-readable medium may be included in the equipment 2600 (e.g., the memory 2620) or other storage equipment which may be accessed by the equipment 2600. The program 2630 may be loaded from the computer-readable medium to the RAM 2622 for execution. The computer-readable medium may include any type of tangible non-volatile memories, such as ROM, EPROM, flash memory, hard disk, CD, DVD, etc.

Fig. 27 illustrates an example of a computer-readable medium 2700 in the form of a CD or DVD. The computer-readable medium has the program 2630 stored thereon.

Generally, various embodiments of the present disclosure may be implemented in hardware or special purpose circuits, software, logic, or any combinations thereof. Some aspects may be implemented in hardware, while other aspects may be implemented in firmware or software, which may be executed by a controller, a microprocessor, or other computing equipment. Although various aspects of the embodiments of the present disclosure are shown and described as block diagrams, flowcharts, or using some other illustrations, it should be understood that the blocks, apparatuses, systems, techniques or methods described herein may be implemented as, for example, nonrestrictive examples, hardware, software, firmware, dedicated circuits or logic, general-purpose hardware or controllers, or other computing equipment, or some combinations thereof.

The present disclosure further provides at least one computer program product, which is tangibly stored on a non-transitory computer-readable storage medium. The computer program product includes computer-executable instructions, such as instructions included in program modules, and the computer-executable instructions are executed in an equipment on a real or virtual processor of a target, so as to execute the method 400 with reference to Fig. 4. Generally, the program modules include routines, programs, libraries, objects, categories, components, data structures, and the like for executing particular tasks or implementing particular abstract data types. In various embodiments, the functions of the program modules may be combined or segmented between the program modules as needed. Machine-executable instructions for the program modules may be executed inside local or distributed equipment. In the distributed equipment, the program modules may be located in local and remote storage media. The term "non-transitory," as used herein, is a limitation of the medium itself (i.e., tangible, not a signal) as opposed to a limitation on data storage persistency (e.g., RAM vs. ROM).

Computer program codes for implementing the method of the present disclosure may be compiled in one or more programming languages. These computer program codes may be provided for processors of general-purpose computers, special-purpose computers, or other programmable data processing apparatuses, such that the program codes, when executed by the computers or the other programmable data processing apparatuses, cause specified functions/operations in the flowcharts and/or block diagrams to be implemented. The program codes may be entirely executed on the computers, partly on the computers, as stand-alone software packages, partly on the computers and partly on remote computers or entirely on the remote computers or servers.

In the context of the present disclosure, the computer program codes or relevant data may be carried by any suitable carriers, so that the equipment, apparatuses or processors may execute the various processing and operations described above. Examples of the carriers include signals, computer-readable media, and the like. Examples of the signals may include electrical, optical, radio, sound, or other forms of propagation signals, such as carriers, infrared signals, and the like.

The computer-readable medium may be any tangible medium, which includes or stores programs for or about instruction execution systems, apparatuses or equipment. The computer-readable medium may be a computer-readable signal medium or a computer-readable storage medium. The computer-readable medium may include, but is not limited to, electronic, magnetic, optical, electromagnetic, infrared or semiconductor systems, apparatuses or equipment, or any suitable combinations thereof. More detailed examples of the computer-readable storage medium include: an electrical connection with one or more wires, a portable computer disk, a hard disk, a random access memory (RAM), a read-only memory (ROM), an erasable programmable read-only memory (EPROM or flash memory), an optical storage equipment, a magnetic storage equipment, or any suitable combinations thereof.

In addition, although the operations of the method of the present disclosure are described in a particular order in the drawings, this does not require or imply that these operations must be executed in the particular order, or that all of the illustrated operations must be executed to achieve the desired results. Rather, the execution order of the steps depicted in the flowcharts may be changed. Additionally or alternatively, some steps may be omitted, a plurality of steps are combined into one step for execution, and/or one step is decomposed into a plurality of steps for execution. It should also be noted that, the features and functions of two or more apparatuses according to the present disclosure may be embodied in one apparatus. Conversely, the features and functions of one apparatus described above may be further divided into a plurality of apparatuses to be embodied.

Although the present disclosure has been described with reference to several specific embodiments, it should be understood that the present disclosure is not limited to the disclosed specific embodiments. The present disclosure is intended to cover various modifications and equivalent arrangements included within the spirit and scope of the appended claims.

**Claims**

1. A method of measurement, comprising:

    during runtime of a radio frequency equipment, obtaining (402), by a coupler in the radio frequency equipment, a forward measurement signal from a first radio frequency device to a second radio frequency device of the radio frequency equipment and a reverse measurement signal from the second radio frequency device to the first radio frequency device;
    determining (404), based on the forward measurement signal, the reverse measurement signal and offline calibration data, a reflection coefficient at a measurement reference plane between the coupler and the second radio frequency device; and
    determining (406), based on the reflection coefficient at the measurement reference plane, a reflection coefficient at a calibration reference plane between the second radio frequency device and a load of the radio frequency equipment.

2. The method according to claim 1, further comprising:
    determining, based on the reflection coefficient at the calibration reference plane, a voltage stand wave ratio at the calibration reference plane during the runtime of the radio frequency equipment.

3. The method according to claim 1 or 2, wherein determining the reflection coefficient at the measurement reference plane comprises:

    determining, based on the offline calibration data, a forward leakage signal leaked from the first radio frequency device to the coupler;
    determining, based on the offline calibration data, a forward insertion loss of the coupler; and
    determining, based on the forward measurement signal, the reverse measurement signal, the forward leakage signal and the forward insertion loss, the reflection coefficient at the measurement reference plane, wherein for example determining the forward leakage signal comprises:

        determining, based on the offline calibration data, a target forward measurement signal and a target forward leakage signal; and
        determining, based on the forward measurement signal, the target forward measurement signal and the target forward leakage signal, the forward leakage signal,

wherein for example determining the forward insertion loss of the coupler comprises:
obtaining, from the offline calibration data, the forward insertion loss obtained by measuring the coupler by a vector network analyzer.

**4.** The method according to any of claims 1-3, wherein determining the reflection coefficient at the calibration reference plane comprises:

determining, based on the offline calibration data, an error parameter set of an error model, the error model representing a reflection coefficient difference between the calibration reference plane and the measurement reference plane; and
obtaining, based on the error model and the error parameter set, the reflection coefficient at the calibration reference plane from the reflection coefficient at the measurement reference plane.

**5.** The method according to claim 4, further comprising:

prior to a running of the radio frequency equipment, executing an equipment-level calibration process to determine the error parameter set,
wherein for example the equipment-level calibration process comprises:

determining a first plurality of reflection coefficients at the measurement reference plane in the event that the radio frequency equipment is respectively connected to a plurality of calibration loads with different impedances;
determining a second plurality of reflection coefficients at the calibration reference plane in the event that the radio frequency equipment is respectively connected to the plurality of calibration loads; and
determining, based on the first plurality of reflection coefficients and the second plurality of reflection coefficients, the error parameter set, wherein for example
determining the second plurality of reflection coefficients comprises:
obtaining the second plurality of reflection coefficients obtained by measuring the plurality of calibration loads by a vector network analyzer.

**6.** The method according to claim 5, wherein determining the first plurality of reflection coefficients comprises:

determining, based on the offline calibration data, a plurality of forward leakage signals in the event that the radio frequency equipment is respectively connected to the plurality of calibration loads;
determining, based on the offline calibration data, a forward insertion loss of the coupler;
obtaining, by the coupler, a plurality of forward measurement signals and a plurality of reverse measurement signals when the radio frequency equipment is respectively connected to the plurality of calibration loads; and
determining, based on the plurality of forward leakage signals, the plurality of forward measurement signals, the plurality of reverse measurement signals and the forward insertion loss, the first plurality of reflection coefficients.

**7.** The method according to claim 6, wherein the equipment-level calibration process further comprises:

in the event that the radio frequency equipment is connected to a spectrum analyzer, determining, based on a target output power at the calibration reference plane, a target transmission gain of the radio frequency equipment; and
in the event that the radio frequency equipment is respectively connected to the plurality of calibration loads, upon the radio frequency equipment provides the target transmission gain, using the coupler to measure the plurality of forward measurement signals and the plurality of reverse measurement signals.

**8.** The method according to claim 6, wherein the equipment-level calibration process further comprises:

determining, based on the offline calibration data, a target forward measurement signal and a target forward leakage signal; and
determining, based on the plurality of forward measurement signals, the target forward measurement signal and the target forward leakage signal, the plurality of forward leakage signals, wherein for example
the method further comprises:

prior to the equipment-level calibration process, executing a half-box-level calibration process to determine the target forward measurement signal and the target forward leakage signal,

wherein for example the half-box-level calibration process comprises:

in the event that the radio frequency equipment in a half-box state provides a target output power at the measurement reference plane, using the coupler to obtain the target forward measurement signal and the target forward leakage signal, wherein the radio frequency equipment in the half-box state does not comprise the second radio frequency device.

9.    The method according to claim 8, wherein during the half-box-level calibration process, the radio frequency equipment is connected to a spectrum analyzer, the coupler is respectively connected to a transmission link of the radio frequency equipment and the spectrum analyzer, the target forward measurement signal is a measured signal from the transmission link to the spectrum analyzer, and the target forward leakage signal is a measured signal leaked from the transmission link to the coupler.

10.   The method according to any of claims 1-9, wherein the radio frequency equipment is a remote radio unit (RRU), the coupler is a bi-direction coupler, the first radio frequency device is a circulator, the second radio frequency device is a cavity filter, and the load is an antenna feed system.

11.   A radio frequency equipment (110; 2600), comprising:

at least one processor (2610); and
at least one memory (2620) storing instructions (2630) that, when executed by the at least one processor (2610), cause the radio frequency equipment (110; 2600) at least to:

during runtime of the radio frequency equipment, obtain (402), by a coupler in the radio frequency equipment, a forward measurement signal from a first radio frequency device to a second radio frequency device of the radio frequency equipment and a reverse measurement signal from the second radio frequency device to the first radio frequency device;
determine (404), based on the forward measurement signal, the reverse measurement signal and offline calibration data, a reflection coefficient at a measurement reference plane between the coupler and the second radio frequency device; and
determine (406), based on the reflection coefficient at the measurement reference plane, a reflection coefficient at a calibration reference plane between the second radio frequency device and a load of the radio frequency equipment.

12.   The radio frequency equipment (110; 2600) according to claim 11, wherein the radio frequency equipment is further caused to:
determine, based on the reflection coefficient at the calibration reference plane, a voltage stand wave ratio at the calibration reference plane during the runtime of the radio frequency equipment.

13.   The radio frequency equipment (110; 2600) according to claim 11 or 12, wherein the radio frequency equipment is caused to determine the reflection coefficient at the measurement reference plane by the following:

determining, based on the offline calibration data, a forward leakage signal leaked from the first radio frequency device to the coupler;
determining, based on the offline calibration data, a forward insertion loss of the coupler; and
determining, based on the forward measurement signal, the reverse measurement signal, the forward leakage signal and the forward insertion loss, the reflection coefficient at the measurement reference plane,
wherein for example the radio frequency equipment is caused to determine the forward leakage signal by the following:

determining, based on the offline calibration data, a target forward measurement signal and a target forward leakage signal; and
determining, based on the forward measurement signal, the target forward measurement signal and the target forward leakage signal, the forward leakage signal,
wherein for example the radio frequency equipment is caused to determine the forward insertion loss of the coupler by the following:
obtaining, from the offline calibration data, the forward insertion loss obtained by measuring the coupler by a vector network analyzer.

14. The radio frequency equipment (110; 2600) according to any of claims 11-13, wherein the radio frequency equipment is caused to determine the reflection coefficient at the calibration reference plane by the following:

determining, based on the offline calibration data, an error parameter set of an error mode, the error model representing a reflection coefficient difference between the calibration reference plane and the measurement reference plane; and
obtaining, based on the error model and the error parameter set, the reflection coefficient at the calibration reference plane from the reflection coefficient at the measurement reference plane,
wherein for example the radio frequency equipment is further caused to:

prior to a running of the radio frequency equipment, execute an equipment-level calibration process to determine the error parameter set,
wherein for example the equipment-level calibration process comprises:

determining a first plurality of reflection coefficients at the measurement reference plane in the event that the radio frequency equipment is respectively connected to a plurality of calibration loads with different impedances;
determining a second plurality of reflection coefficients at the calibration reference plane in the event that the radio frequency equipment is respectively connected to the plurality of calibration loads; and
determining, based on the first plurality of reflection coefficients and the second plurality of reflection coefficients, the error parameter set,
wherein for example the radio frequency equipment is caused to determine the second plurality of reflection coefficients by the following:

obtaining the second plurality of reflection coefficients obtained by measuring the plurality of calibration loads by the vector network analyzer, wherein
for example the radio frequency equipment is caused to determine the first plurality of reflection coefficients by:

determining, based on the offline calibration data, a plurality of forward leakage signals in the event that the radio frequency equipment is respectively connected to the plurality of calibration loads;
determining, based on the offline calibration data, the forward insertion loss of the coupler;
obtaining, by the coupler, a plurality of forward measurement signals and a plurality of reverse measurement signals when the radio frequency equipment is respectively connected to the plurality of calibration loads; and
determining, based on the plurality of forward leakage signals, the plurality of forward measurement signals, the plurality of reverse measurement signals and the forward insertion loss, the first plurality of reflection coefficients, wherein for example
the equipment-level calibration process further comprises:

in the event that the radio frequency equipment is connected to a spectrum analyzer, determining, based on a target output power at the calibration reference plane, a target transmission gain of the radio frequency equipment; and
in the event that the radio frequency equipment is respectively connected to the plurality of calibration loads, upon the radio frequency equipment provides the target transmission gain, using the coupler to measure the plurality of forward measurement signals and the plurality of reverse measurement signals,
wherein for example the equipment-level calibration process further comprises:

determining, based on the offline calibration data, a target forward measurement signal and a target forward leakage signal; and
determining, based on the plurality of forward measurement signals, the target forward measurement signal and the target forward leakage signal, the plurality of forward leakage signals,
wherein for example the radio frequency equipment is further caused to:

prior to the equipment-level calibration process, execute a half-box-level calibration process, to determine the target forward measurement signal and the target forward leakage signal.

15. The radio frequency equipment (110; 2600) according to claim 14, wherein the half-box-level calibration process comprises:
in the event that the radio frequency equipment in a half-box state provides a target output power at the measurement reference plane, using the coupler to obtain the target forward measurement signal and the target forward leakage signal, wherein the radio frequency equipment in the half-box state does not comprise the second radio frequency device.

16. The radio frequency equipment (110; 2600) according to claim 14 or 15, wherein during the half-box-level calibration process, the radio frequency equipment is connected to a spectrum analyzer, the coupler is respectively connected to a transmission link of the radio frequency equipment and the spectrum analyzer, the target forward measurement signal is a measured signal from the transmission link to the spectrum analyzer, and the target forward leakage signal is a measured signal leaked from the transmission link to the coupler.

17. The radio frequency equipment (110; 2600) according to any of claims 11-16, wherein the radio frequency equipment is a remote radio unit (RRU), the coupler is a bi-direction coupler, the first radio frequency device is a circulator, the second radio frequency device is a cavity filter, and the load is an antenna feed system.

18. An apparatus of measurement, comprising:

means for during runtime of a radio frequency equipment, obtaining, by a coupler in the radio frequency equipment, a forward measurement signal from a first radio frequency device to a second radio frequency device of the radio frequency equipment and a reverse measurement signal from the second radio frequency device to the first radio frequency device;
means for determining, based on the forward measurement signal, the reverse measurement signal and offline calibration data, a reflection coefficient at a measurement reference plane between the coupler and the second radio frequency device; and
means for determining, based on the reflection coefficient at the measurement reference plane, a reflection coefficient at a calibration reference plane between the second radio frequency device and a load of the radio frequency equipment.

19. A computer-readable medium (2700) having program instructions stored thereon for at least performing the method of any of claims 1-10.

100

110                                  120

Radio frequency
equipment                              Load

Fig. 1

Fig. 2

Fig. 3

400 ⌐

402

A radio frequency equipment, obtains, during runtime and by a coupler in the radio frequency equipment, a forward measurement signal from a first radio frequency device to a second radio frequency device of the radio frequency equipment and a reverse measurement signal from the second radio frequency device to the first radio frequency device

404

The radio frequency equipment determines, based on the forward measurement signal from the first radio frequency device to the second radio frequency device, the reverse measurement signal from the second radio frequency device to the first radio frequency device, and offline calibration data, a reflection coefficient at a measurement reference plane between the coupler and the second radio frequency device

406

The radio frequency equipment determines, based on the reflection coefficient at the measurement reference plane, a reflection coefficient at a calibration reference plane between the second radio frequency device and a load of the radio frequency equipment

# Fig. 4

500 ⌐

502

Determine, based on the offline calibration data, a forward leakage signal leaked from the first radio frequency device to the coupler

504

Determine, based on the offline calibration data, a forward insertion loss of the coupler

506

Determine, based on the forward measurement signal from the first radio frequency device to the second radio frequency device, the reverse measurement signal from the second radio frequency device to the first radio frequency device, the forward leakage signal leaked from the first radio frequency device to the coupler, and the forward insertion loss of the coupler, the reflection coefficient at the measurement reference plane

# Fig. 5

600 ⌇

┌─────────────────────────────────────────────── 602
│ Determine a first plurality of reflection coefficients at
│ the measurement reference plane in the event that the
│ radio frequency equipment is respectively connected
│ to a plurality of calibration loads with different
│ impedances
└───────────────────────────────────────────────

┌─────────────────────────────────────────────── 604
│ Determine a second plurality of reflection coefficients
│ at the calibration reference plane in the event that the
│ radio frequency equipment is respectively connected
│ to the plurality of calibration loads
└───────────────────────────────────────────────

┌─────────────────────────────────────────────── 606
│ Determine, based on the first plurality of reflection
│ coefficients and the second plurality of reflection
│ coefficients, an error parameter set
└───────────────────────────────────────────────

Fig. 6

700

702

Determine, based on the offline calibration data, a plurality of forward leakage signals in the event that the radio frequency equipment is respectively connected to the plurality of calibration loads

704

Determine, based on the offline calibration data, the forward insertion loss of the coupler

706

Obtain, by the coupler, a plurality of forward measurement signals and a plurality of reverse measurement signals when the radio frequency equipment is respectively connected to the plurality of calibration loads

708

Determine, based on the plurality of forward leakage signals, the plurality of forward measurement signals, the plurality of reverse measurement signals and the forward insertion loss, the first plurality of reflection coefficients

Fig. 7

$a_{1C}$

1

$a_{1M}$

EDF

ESF

$S_{11C}$

$b_{1M}$

ERF

$b_{1C}$

Measurement reference plane

Calibration reference plane

Fig. 8

Fig. 9

Fig. 10

| Known conditions | | | | | | | Calculated parameters | | | | | | |
|---|---|---|---|---|---|---|---|---|---|---|---|---|---|
| $\lvert S_A \rvert$ | $\lvert S_{CA} \rvert$ | $RL_{Filter}$ | $IL_{Filter}$ | $VSWR_{load}$ | $RL_{Load}$ | $\lvert S_{CB} \rvert = \lvert S_{DA} \rvert$ | $\lvert S_{RFD} \rvert$ | $\lvert S_{FLD} \rvert$ | $\lvert S_{FM} \rvert$ | $\lvert S_{RUM} \rvert$ | $\lvert S_{RWM} \rvert$ | $\lvert S_{RM} \rvert_{max}$ | $\lvert S_{RM} \rvert_{min}$ |
| dBm | dB | | | | dB | dB | dBm | dBm | dBm | dBm | dBm | dBm | dBm |
| dBm | $= \lvert Coupling_{coupler} \rvert$ | dB | dB | linear | $= 20*\log((VSWR-1)/(VSWR+1))$ | $= \lvert Direction_{coupler} \rvert$ | $= \lvert S_A \rvert - \lvert S_{CA} \rvert$ | $= \lvert S_A \rvert - \lvert S_{DA} \rvert$ | $= 10*\log(10^{\wedge}(\lvert S_A \rvert/10) - 10^{\wedge}(\lvert S_{RFD} \rvert/10) - 10^{\wedge}(\lvert S_{FLD} \rvert/10))$ | $= \lvert S_{FM} \rvert + RL_{Filter}$ | $= \lvert S_{FM} \rvert + IL_{Filter} + RL_{Load} + IL_{Filter}$ | $= 10*\log(10^{\wedge}(\lvert S_{RUM} \rvert/10) + 10^{\wedge}(\lvert S_{RWM} \rvert/10))$ | $= 10*\log(abs(10^{\wedge}(\lvert S_{RUM} \rvert/10) - 10^{\wedge}(\lvert S_{RWM} \rvert/10)))$ |
| 0 | 20 | -18 | -1 | 1.1 | -26.4 | 30 | -20 | -30 | -0.05 | -18.05 | -28.49 | -17.67 | -18.46 |
| 0 | 20 | -18 | -1 | 1.5 | -14 | 30 | -20 | -30 | -0.05 | -18.05 | -16.03 | -13.91 | -20.32 |
| 0 | 20 | -18 | -1 | 2 | -9.54 | 30 | -20 | -30 | -0.05 | -18.05 | -11.59 | -10.71 | -12.70 |
| 0 | 20 | -18 | -1 | 3 | -6.02 | 30 | -20 | -30 | -0.05 | -18.05 | -8.07 | -7.65 | -8.53 |
| 0 | 20 | -18 | -1 | 4 | -4.44 | 30 | -20 | -30 | -0.05 | -18.05 | -6.49 | -6.19 | -6.80 |
| 0 | 20 | -18 | -1 | 5 | -3.52 | 30 | -20 | -30 | -0.05 | -18.05 | -5.57 | -5.33 | -5.82 |

Fig. 11

Fig. 12

| | | | Known conditions | | | | | | | | | | Calculated parameters | | | | | | | | | | |
|---|---|---|---|---|---|---|---|---|---|---|---|---|---|---|---|---|---|---|---|---|---|---|---|
| $\lvert S_A\rvert$ | $\lvert S_{CA}\rvert = \lvert S_D\rvert$ | $RL_{Filter}$ | $IL_{Filter}$ | $VSWR_{load}$ | $RL_{Load}$ | $\lvert S_{CB}\rvert = \lvert S_{DA}\rvert$ | ISO SPDT | $\lvert S_{RFD}\rvert$ | $\lvert S_{RLD}\rvert$ | $\lvert S_{FM}\rvert$ | $\lvert S_{RUM}\rvert$ | $\lvert S_{RWM}\rvert$ | $\lvert S_{RM}\rvert max$ | $\lvert S_{RM}\rvert min$ | $\lvert S_{RRD}\rvert max$ | $\lvert S_{RRD}\rvert min$ | $\lvert S_{RLD}\rvert max$ | $\lvert S_{FDT}\rvert max$ | $\lvert S_{RDT}\rvert\_1$ (max) | $\lvert S_{RDT}\rvert\_2$ (min) | $\lvert S_{FDTL}\rvert max$ | $\lvert S_{RDT\_M}\rvert\_1$ (max) | $\lvert S_{RDT\_M}\rvert\_2$ (min) |
| dBm | dB | | | | dB | dB | dB | dBm | dBm | dBm | dBm | dBm | dBm | dBm | dBm | dBm | dBm | dBm | dBm | dBm | dBm | dBm | dBm |
| dBm | $=\lvert Coupling_{coupler}\rvert$ | dB | dB | linear | $=20\ast\log((VSWR-1)/(VSWR+1))$ | $=\lvert Direction_{coupler}\rvert$ | dB | $=\lvert S_A\rvert-\lvert S_{CA}\rvert$ | $=\lvert S_A\rvert-\lvert S_{DA}\rvert$ | $=10\ast\log(10^{\wedge}(\lvert S_A\rvert/10)-10^{\wedge}(\lvert S_{RFD}\rvert/10)-10^{\wedge}(\lvert S_{RLD}\rvert/10))$ | $=\lvert S_{RFl}\rvert+RL_{Filter}$ | $=\lvert S_{FM}\rvert+IL_{Filter}+RL_{Load}+IL_{Filter}$ | $=10\ast\log(10^{\wedge}(\lvert S_{RUM}\rvert/10)+10^{\wedge}(\lvert S_{RWM}\rvert/10))$ | $=10\ast\log(\mathrm{abs}(10^{\wedge}(\lvert S_{RUM}\rvert/10)-10^{\wedge}(\lvert S_{RWM}\rvert/10)))$ | $=\lvert S_{RM}\rvert max-\lvert S_{DB}\rvert$ | $=\lvert S_{RM}\rvert min-\lvert S_{DB}\rvert$ | $=\lvert S_{RM}\rvert max-\lvert S_{CB}\rvert$ | $=10\ast\log(10^{\wedge}(\lvert S_{RRD}\rvert max/10)+10^{\wedge}(\lvert S_{RLD}\rvert max/10))$ | $=10\ast\log(10^{\wedge}((\lvert S_{RRD}\rvert max)/10)+10^{\wedge}(\lvert S_{RLD}\rvert/10))$ | $=10\ast\log(10^{\wedge}((\lvert S_{RRD}\rvert min)/10)-10^{\wedge}(\lvert S_{RLD}\rvert/10))$ | $=\lvert S_{FDT}\rvert max-\lvert ISO_{SPDT}\rvert$ | $=10\ast\log(10^{\wedge}((\lvert S_{RDT}\rvert max)/10)+10^{\wedge}(\lvert S_{FDTL}\rvert max)/10))$ | $=10\ast\log(10^{\wedge}((\lvert S_{RDT}\rvert min)/10)-10^{\wedge}(\lvert S_{FDTL}\rvert max)/10))$ |
| 0 | 20 | -18 | -1 | 1.1 | -26 | 30 | 30 | -20 | -30 | -0.05 | -18.05 | -28.49 | -17.67 | -18.46 | -37.67 | -38.46 | -47.67 | -19.99 | -29.31 | -30.67 | -49.99 | -29.28 | -30.72 |
| 0 | 20 | -18 | -1 | 1.5 | -14 | 30 | 30 | -20 | -30 | -0.05 | -18.05 | -16.03 | -13.91 | -20.32 | -33.91 | -40.32 | -43.91 | -19.98 | -28.52 | -30.42 | -49.98 | -28.49 | -30.47 |
| 0 | 20 | -18 | -1 | 2 | -9.5 | 30 | 30 | -20 | -30 | -0.05 | -18.05 | -11.59 | -10.71 | -12.70 | -30.71 | -32.70 | -40.71 | -19.96 | -27.33 | -33.34 | -49.96 | -27.30 | -33.44 |
| 0 | 20 | -18 | -1 | 3 | -6 | 30 | 30 | -20 | -30 | -0.05 | -18.05 | -8.07 | -7.65 | -8.53 | -27.65 | -28.53 | -37.65 | -19.93 | -25.66 | -33.94 | -49.93 | -25.64 | -34.05 |
| 0 | 20 | -18 | -1 | 4 | -4.4 | 30 | 30 | -20 | -30 | -0.05 | -18.05 | -6.49 | -6.19 | -6.80 | -26.19 | -26.80 | -36.19 | -19.90 | -24.68 | -29.63 | -49.90 | -24.67 | -29.67 |
| 0 | 20 | -18 | -1 | 5 | -3.5 | 30 | 30 | -20 | -30 | -0.05 | -18.05 | -5.57 | -5.33 | -5.82 | -25.33 | -25.82 | -35.33 | -19.87 | -24.06 | -27.91 | -49.87 | -24.04 | -27.94 |

Fig. 13

Fig. 14

| | Known conditions | | | | | | | | Calculated parameters | | | | | | | | | | | | | |
|---|---|---|---|---|---|---|---|---|---|---|---|---|---|---|---|---|---|---|---|---|---|---|
| |SA| | |SCA|=|SDB| | RLFilter | ILFilter | VSWRload | RLLoad | |SCB|=|SDA| | ISOSPDT | |SRFD| | |SFLD| | |SFM| | |SRUM| | |SRWM| | |SRM|max | |SRRD|max | |SRLD|max | |SFDT|_1 (max) | |SFDT|_2 (min) | |SRDT|max | |SRDTL|max | |SFDT_M|_1 (max) | |SFDT_M|_2 (min) |
| dBm | dB =\|Coupling coupler\| | dB | dB | linear | dB =20*log((VSWR-1)/(VSWR+1)) | dB =\|Direction coupler\| | dB | dBm =\|SA\|-\|SCA\| | dBm =\|SA\|-\|SDA\| | dBm =10*log(10^(\|SRFD\|/10)-10^(\|SFLD\|/10)) | dBm =\|SFM\|+RLFilter | dBm =\|SFM\|+ILFilter+RLLoad+ILFilter | dBm =10*log(10^(\|SRUM\|/10)+10^(\|SRWM\|/10)) | dBm =\|SRM\|max-\|SCB\| | dBm =\|SRM\|max-\|SCB\| | dBm =10*log(10^(\|SRFD\|/10)+10^(\|SRLD\|max/10)) | dBm =10*log(10^(\|SRFD\|/10)-10^(\|SRLD\|max/10)) | dBm =10*log(10^(\|SRRD\|max/10)+10^(\|SFLD\|/10)) | dBm =\|SRDTL\|max-\|ISOSPDT\| | dBm =10*log(10^(\|SFDT\|max/10)+10^(\|SRDTL\|min/10)) | dBm =10*log(10^(\|SFDT\|min/10)-10^(\|SRDTL\|min/10)) |
| 0 | 20 | -18 | -1 | 1.1 | -26.4 | 30 | 30 | -20 | -30 | -0.05 | -18.05 | -28.49 | -17.67 | -37.67 | -47.67 | -19.99 | -20.01 | -29.31 | -59.31 | -19.99 | -20.01 |
| 0 | 20 | -18 | -1 | 1.5 | -14 | 30 | 30 | -20 | -30 | -0.05 | -18.05 | -16.03 | -13.91 | -33.91 | -43.91 | -19.98 | -20.02 | -28.52 | -58.52 | -19.98 | -20.02 |
| 0 | 20 | -18 | -1 | 2 | -9.54 | 30 | 30 | -20 | -30 | -0.05 | -18.05 | -11.59 | -10.71 | -30.71 | -40.71 | -19.96 | -20.04 | -27.33 | -57.33 | -19.96 | -20.04 |
| 0 | 20 | -18 | -1 | 3 | -6.02 | 30 | 30 | -20 | -30 | -0.05 | -18.05 | -8.07 | -7.65 | -27.65 | -37.65 | -19.93 | -20.08 | -25.66 | -55.66 | -19.92 | -20.08 |
| 0 | 20 | -18 | -1 | 4 | -4.44 | 30 | 30 | -20 | -30 | -0.05 | -18.05 | -6.49 | -6.19 | -26.19 | -36.19 | -19.90 | -20.11 | -24.68 | -54.68 | -19.90 | -20.11 |
| 0 | 20 | -18 | -1 | 5 | -3.52 | 30 | 30 | -20 | -30 | -0.05 | -18.05 | -5.57 | -5.33 | -25.33 | -35.33 | -19.87 | -20.13 | -24.06 | -54.06 | -19.87 | -20.13 |

Fig. 15

Fig.16

| Known conditions | | | | Calculated parameters | | | | | | | |
|---|---|---|---|---|---|---|---|---|---|---|---|
| $\lvert S_A\rvert$ | $\lvert S_{CA}\rvert$ $=\lvert S_{DB}\rvert$ | $\lvert S_{CB}\rvert$ $=\lvert S_{DA}\rvert$ | $ISO_{SPDT}$ | $\lvert S_{RFD}\rvert$ | $\lvert S_{FLD}\rvert$ | $\lvert S_{RFDL}\rvert$ | $\lvert S_{FLDL}\rvert$ | $\lvert S_{RFD\_M}\rvert_{max}$ | $\lvert S_{RFD\_M}\rvert_{min}$ | $\lvert S_{FLD\_M}\rvert_{max}$ | $\lvert S_{FLD\_M}\rvert_{min}$ |
| dBm | dB | dB | dB | dBm | dBm | dBm | dBm | dBm | dBm | dBm | dBm |
|  | $=\lvert Coulpling_{coupler}\rvert$ | $=\lvert Direction_{coupler}\rvert$ |  | $=\lvert S_A\rvert-\lvert S_{CA}\rvert$ | $=\lvert S_A\rvert-\lvert S_{DA}\rvert$ | $=\lvert S_{RFD}\rvert-\lvert ISO_{SPDT}\rvert$ | $=\lvert S_{FLD}\rvert-\lvert ISO_{SPDT}\rvert$ | $=10*\log(10^{\wedge}(\lvert S_{RFD}\rvert/10)+10^{\wedge}(\lvert S_{FLDL}\rvert/10))$ | $=10*\log(10^{\wedge}(\lvert S_{FLDL}\rvert/10)-10^{\wedge}(\lvert S_{RFD}\rvert/10))$ | $=10*\log(10^{\wedge}(\lvert S_{FLD}\rvert/10)+10^{\wedge}(\lvert S_{RFDL}\rvert/10))$ | $=10*\log(10^{\wedge}(\lvert S_{RFDL}\rvert/10)-10^{\wedge}(\lvert S_{FLDL}\rvert/10))$ |
| 0 | 20 | 30 | 30 | -20 | -30 | -50 | -60 | -20.00 | -20.00 | -30.00 | -30.04 |

Fig.17

(i)  The impaction of DPD signal leaking to VSWR reverse detection

| $P_{DPD}$ | $VSWR_{load}$ | $P_{VSWR\_reverse1}$ ($|S_{RDT}|max$) | ISO_MUX | $P_{DPDL}$ | $P_{VSWR\_reverse1\_Measured\_max}$ | $P_{VSWR\_reverse1\_Measured\_min}$ | $P_{VSWR\_reverse2}$ ($|S_{RDT}|min$) | ISO_MUX | $P_{DPDL}$ | $P_{VSWR\_reverse2\_Measured\_max}$ | $P_{VSWR\_reverse2\_Measured\_min}$ |
|---|---|---|---|---|---|---|---|---|---|---|---|
| | | | | dBm | dBm | dBm | | | dBm | dBm | dBm |
| dBm | Linear | dBm | dB | $=|P_{DPD}|-|ISO\_MUX|$ | $=10*log(10^\wedge(|P_{VSWR\_reverse1}|/10)+10^\wedge(|P_{DPDL}|/10))$ | $=10*log(10^\wedge(|P_{VSWR\_reverse1}|/10)-10^\wedge(|P_{DPDL}|/10))$ | dBm | dB | $=|P_{DPD}|-|ISO\_MUX|$ | $=10*log(10^\wedge(|P_{VSWR\_reverse2}|/10)+10^\wedge(|P_{DPDL}|/10))$ | $=10*log(10^\wedge(|P_{VSWR\_reverse2}|/10)-10^\wedge(|P_{DPDL}|/10))$ |
| -20.5 | 1.1 | -29.31 | 30 | -50.5 | -29.28 | -29.35 | -30.67 | 30 | -50.5 | -30.62 | -30.71 |
| -20.5 | 1.5 | -28.52 | 30 | -50.5 | -28.49 | -28.55 | -30.42 | 30 | -50.5 | -30.38 | -30.47 |
| -20.5 | 2 | -27.33 | 30 | -50.5 | -27.31 | -27.35 | -33.34 | 30 | -50.5 | -33.26 | -33.42 |
| -20.5 | 3 | -25.66 | 30 | -50.5 | -25.65 | -25.67 | -33.94 | 30 | -50.5 | -33.85 | -34.04 |
| -20.5 | 4 | -24.68 | 30 | -50.5 | -24.67 | -24.69 | -29.63 | 30 | -50.5 | -29.59 | -29.67 |
| -20.5 | 5 | -24.06 | 30 | -50.5 | -24.05 | -24.07 | -27.91 | 30 | -50.5 | -27.89 | -27.94 |

Fig.18 (i)

(ii) The impaction of VSWR reverse detection leaking to DPD signal

| VSWR_load | $P_{DPD}$ | $P_{VSWR\_reverse1}$ (\|$S_{RDT}$\| max) | ISO_MUX | $P_{VSWR\_reverse1\_L}$ | $P_{DPD\_Measured}$ | $P_{DPD}$ | $P_{VSWR\_reverse2}$ (\|$S_{RDT}$\| min) | ISO_MUX | $P_{VSWR\_reverse2\_L}$ | $P_{DPD\_Measured\_max}$ | $P_{DPD\_Measured\_min}$ |
|---|---|---|---|---|---|---|---|---|---|---|---|
| | | | | dBm | dBm | | | | dBm | dBm | dBm |
| Linear | dBm | dBm | dB | $=\|S_{RDT}\|max-\|ISO\_MUX\|$ | $=\|P_{DPD}\|+\|P_{VSW\_reverse1\_L}\|$ | dBm | dBm | dB | $=\|S_{RDT}\|min-\|ISO\_MUX\|$ | $=\|P_{DPD}\|+\|P_{VSW\_reverse2\_L}\|$ | $=\|P_{DPD}\|-\|P_{VSW\_reverse2\_L}\|$ |
| 1.1 | -20.5 | -29.31 | 30 | -59.31 | -20.50 | -20.5 | -30.67 | 30 | -50.5 | -20.50 | -20.50 |
| 1.5 | -20.5 | -28.52 | 30 | -58.52 | -20.50 | -20.5 | -30.42 | 30 | -50.5 | -20.50 | -20.50 |
| 2 | -20.5 | -27.33 | 30 | -57.33 | -20.50 | -20.5 | -33.34 | 30 | -50.5 | -20.50 | -20.50 |
| 3 | -20.5 | -25.66 | 30 | -55.66 | -20.50 | -20.5 | -33.94 | 30 | -50.5 | -20.50 | -20.50 |
| 4 | -20.5 | -24.68 | 30 | -54.68 | -20.50 | -20.5 | -29.63 | 30 | -50.5 | -20.50 | -20.50 |
| 5 | -20.5 | -24.06 | 30 | -54.06 | -20.50 | -20.5 | -27.91 | 30 | -50.5 | -20.50 | -20.50 |

Fig.18 (ii)

(iii) The impaction of DPD signal leaking to VSWR forward detection

| $P_{DPD}$ | $VSWR_{load}$ | $P_{VSWR\_forward1}$ ($|S_{FDT}|_{max}$) | ISO_MUX | $P_{DPDL}$ | $P_{VSWR\_forward1\_Measured\_max}$ | $P_{VSWR\_forward1\_Measured\_min}$ | $P_{VSWR\_forward2}$ ($|S_{FDT}|_{min}$) | ISO_MUX | $P_{DPDL}$ | $P_{VSWR\_forward2\_Measured\_max}$ | $P_{VSWR\_forward2\_Measured\_min}$ |
|---|---|---|---|---|---|---|---|---|---|---|---|
| | | | | dBm | dBm | dBm | | | dBm | dBm | dBm |
| dBm | Linear | dBm | dB | $=|P_{DPD}|-|ISO\_MUX|$ | $=10*log(10\wedge(|P_{VSWR\_reverse1}|/10)+10\wedge(|P_{DPDL}|/10))$ | $=10*log(10\wedge(|P_{VSWR\_reverse1}|/10)-10\wedge(|P_{DPDL}|/10))$ | dBm | dB | $=|P_{DPD}|-|ISO\_MUX|$ | $=10*log(10\wedge(|P_{VSWR\_reverse2}|/10)+10\wedge(|P_{DPDL}|/10))$ | $=10*log(10\wedge(|P_{VSWR\_reverse2}|/10)-10\wedge(|P_{DPDL}|/10))$ |
| -20.5 | 1.1 | -19.99 | 30 | -50.5 | -19.99 | -20.00 | -20.01 | 30 | -50.5 | -20.00 | -20.01 |
| -20.5 | 1.5 | -19.98 | 30 | -50.5 | -19.98 | -19.99 | -20.02 | 30 | -50.5 | -20.01 | -20.02 |
| -20.5 | 2 | -19.96 | 30 | -50.5 | -19.96 | -19.97 | -20.04 | 30 | -50.5 | -20.03 | -20.04 |
| -20.5 | 3 | -19.93 | 30 | -50.5 | -19.92 | -19.93 | -20.08 | 30 | -50.5 | -20.07 | -20.08 |
| -20.5 | 4 | -19.90 | 30 | -50.5 | -19.89 | -19.90 | -20.11 | 30 | -50.5 | -20.10 | -20.11 |
| -20.5 | 5 | -19.87 | 30 | -50.5 | -19.87 | -19.88 | -20.13 | 30 | -50.5 | -20.13 | -20.13 |

Fig.18 (iii)

(iv) The impaction of VSWR forward detection leaking to DPD signal

| VSWR$_{load}$ | P$_{DPD}$ | P$_{VSWR\_forward1}$ (\|S$_{FDT}$\|max) | ISO_MUX | P$_{VSWR\_forward1\_L}$ | P$_{DPD\_Measured}$ | P$_{DPD}$ | P$_{VSWR\_forward2}$ (\|S$_{FDT}$\|min) | ISO_MUX | P$_{VSWR\_forward\ d2\_L}$ | P$_{DPD\_Measured\_max}$ | P$_{DPD\_Measured\_min}$ |
| | | | | dBm | dBm | | | | dBm | dBm | dBm |
| Linear | dBm | dBm | dB | $=\|S_{RDT}\|_{max}-\|ISO\_MUX\|$ | $=\|P_{DPD}\|+\|P_{VSW\_forward1\_L}\|$ | dBm | dBm | dB | $=\|S_{FDT}\|_{min}-\|ISO\_MUX\|$ | $=\|P_{DPD}\|+\|P_{VSW\_forward2\_L}\|$ | $=\|P_{DPD}\|-\|P_{VSW\_forward2\_L}\|$ |
|---|---|---|---|---|---|---|---|---|---|---|---|
| 1.1 | -20.5 | -19.99 | 30 | -49.99 | -20.50 | -20.5 | -20.01 | 30 | -50.5 | -20.50 | -20.50 |
| 1.5 | -20.5 | -19.98 | 30 | -49.98 | -20.50 | -20.5 | -20.02 | 30 | -50.5 | -20.50 | -20.50 |
| 2 | -20.5 | -19.96 | 30 | -49.96 | -20.50 | -20.5 | -20.04 | 30 | -50.5 | -20.50 | -20.50 |
| 3 | -20.5 | -19.93 | 30 | -49.93 | -20.50 | -20.5 | -20.08 | 30 | -50.5 | -20.50 | -20.50 |
| 4 | -20.5 | -19.90 | 30 | -49.90 | -20.50 | -20.5 | -20.09 | 30 | -50.5 | -20.50 | -20.50 |
| 5 | -20.5 | -19.87 | 30 | -49.87 | -20.49 | -20.5 | -20.13 | 30 | -50.5 | -20.50 | -20.50 |

Fig.18 (iv)

Fig.19

| | Known conditions | | | | | | | Calculated parameters | | | | | | | | |
|---|---|---|---|---|---|---|---|---|---|---|---|---|---|---|---|---|
| $\|S_A\|$ | $\|S_{CA}\|$ | $RL_{Filter}$ | $IL_{Filter}$ | $VSWR_{load}$ | $RL_{Load}$ | $\|S_{CB}\|$ $=\|S_{DA}\|$ | | $\|S_{RFD}\|$ | $\|S_{RLD}\|$ | $\|S_{FM}\|$ | $\|S_{RUM}\|$ | $\|S_{RWM}\|$ | $\|S_{RM}\|_{max}$ | $\|S_{RLD}\|_{max}$ | $\|S_{RDT}\|_{max}$ | $\|S_{RDT}\|_{min}$ |
| dBm | dB | dB | dB | linear | dB | dB | | dBm | dBm | dBm | dBm | dBm | dBm | dBm | dBm | dBm |
| | $=\|Coupling_{coupler}\|$ | | | | $=20*\log((VSWR-1)/(VSWR+1))$ | $=\|Direction_{coupler}\|$ | | $=\|S_A\|-\|S_{CA}\|$ | $=\|S_A\|-\|S_{DA}\|$ | $=10*\log(10^{\wedge}(\|S_A\|/10)-10^{\wedge}(\|S_{RFD}\|/10)-10^{\wedge}(\|S_{RLD}\|/10))$ | $=\|S_{FM}\|+RL_{Filter}$ | $=\|S_{FM}\|+IL_{Filter}+RL_{Load}+IL_{Filter}$ | $=10*\log(10^{\wedge}(\|S_{RUM}\|/10)+10^{\wedge}(\|S_{RWM}\|/10))$ | $=\|S_{RM}\|_{max}-\|S_{CA}\|$ | $=10*\log(10^{\wedge}(\|S_{RFD}\|/10)+10^{\wedge}(\|S_{RLD}\|_{max}/10))$ | $=10*\log(10^{\wedge}(\|S_{RFD}\|/10)-10^{\wedge}(\|S_{RLD}\|_{max}/10))$ |
| 0 | 20 | -18 | -1 | 1.1 | -26 | 30 | | -20 | -30 | -0.05 | -18.05 | -28.49 | -17.67 | -47.67 | -19.99 | -20.01 |
| 0 | 20 | -18 | -1 | 1.5 | -14 | 30 | | -20 | -30 | -0.05 | -18.05 | -16.03 | -13.91 | -43.91 | -19.98 | -20.02 |
| 0 | 20 | -18 | -1 | 2 | -9.5 | 30 | | -20 | -30 | -0.05 | -18.05 | -11.59 | -10.71 | -40.71 | -19.96 | -20.04 |
| 0 | 20 | -18 | -1 | 3 | -6 | 30 | | -20 | -30 | -0.05 | -18.05 | -8.07 | -7.65 | -37.65 | -19.93 | -20.08 |
| 0 | 20 | -18 | -1 | 4 | -4.4 | 30 | | -20 | -30 | -0.05 | -18.05 | -6.49 | -6.19 | -36.19 | -19.90 | -20.11 |
| 0 | 20 | -18 | -1 | 5 | -3.5 | 30 | | -20 | -30 | -0.05 | -18.05 | -5.57 | -5.33 | -35.33 | -19.87 | -20.13 |

Fig.20

EP 4 312 036 A1

Fig.21

Half-box-level RRU (a cavity filter has not still been assembled)     Instrument

Fig.22

Fig.23

| Step | Phase | DUT | Tool | Parameters | | Storage Medium |
|---|---|---|---|---|---|---|
| | | | | Measured value | Calculated value | |
| 1 | Device-level offline calibration | Bi-direction coupler | VNA | $\overrightarrow{S_{BA}}$ | NA | Memory of RRU |
| 2 | Half-box-level offline calibration | Half-box-level RRU (before the cavity filter is assembled) | SA, Processor of RRU | $\overrightarrow{S_{RFD\_target}}, \overrightarrow{S_{FLD\_target}}$ | NA | Memory of RRU |
| 3 | RRU-level offline calibration | Tool-box | VNA | $\overrightarrow{S_{11C\_Z1}}, \overrightarrow{S_{11C\_Z2}}, \overrightarrow{S_{11C\_Z3}}$ | NA | External computer |
| | | RRU+ Tool-box | SA, Processor of RRU | $\overrightarrow{S_{RFD\_runtime\_Z1}}, \overrightarrow{S_{RDT\_runtime\_Z1}}$ $\overrightarrow{S_{RFD\_runtime\_Z2}}, \overrightarrow{S_{RDT\_runtime\_Z2}}$ $\overrightarrow{S_{RFD\_runtime\_Z3}}, \overrightarrow{S_{RDT\_runtime\_Z3}}$ | $\overrightarrow{S_{FLD\_runtime\_Z1}}, \overrightarrow{S_{11M\_Z1}}$ $\overrightarrow{S_{FLD\_runtime\_Z2}}, \overrightarrow{S_{11M\_Z2}}$ $\overrightarrow{S_{FLD\_runtime\_Z3}}, \overrightarrow{S_{11M\_Z3}}$ | External computer |
| | | | External computer | NA | $\overrightarrow{EDF}, \overrightarrow{ERF}, \overrightarrow{ESF}$ | Memory of RRU |
| 4 | RRU-level runtime measurement | RRU+ Antenna feed system | Processor of RRU + Memory of RRU | $\overrightarrow{S_{RFD\_runtime}}, \overrightarrow{S_{RDT\_runtime}}$ | $\overrightarrow{S_{FLD\_runtime}}, \overrightarrow{S_{11M\_runtime}}$ $\overrightarrow{S_{11C\_runtime}}$ $VSWR_{C\_runtime}$ | NA |

Fig.24

Use a VNA to measure $\overrightarrow{S_{BA}}$
of the bi-direction coupler, and save it in the memory

Device-level
offline calibration

Adjust TX gain to make output power equal to $P_{outM\_target}$

Record $\overrightarrow{S_{RFD\_target}}$ and $\overrightarrow{S_{FLD\_target}}$,
and save them in the memory

Half-box-level
offline calibration

Use a VNA to measure the real S11 of points E of toolbox for
different impedance: $\overrightarrow{S_{11C\_Z1}}$, $\overrightarrow{S_{11C\_Z2}}$ and $\overrightarrow{S_{11C\_Z3}}$

Make the SA of toolbox connect to the output port of RRU, and
adjust TX gain to make output power equal to $P_{outC\_target}$

Make the load port of toolbox to connect to the output
port of RRU, and record $\overrightarrow{S_{11M\_Z1}}$, $\overrightarrow{S_{11M\_Z2}}$ and $\overrightarrow{S_{11M\_Z3}}$

Calculate $\overrightarrow{EDF}$, $\overrightarrow{ERF}$ and $\overrightarrow{ESF}$,
and save them in the memory

RRU-level offline
calibration

Make the antenna feed port to connect to the
output port of RRU, and record $\overrightarrow{S_{RDT\_runtime}}$ and $\overrightarrow{S_{RFD\_runtime}}$

Calculate $\overrightarrow{S_{11M\_runtime}}$, $\overrightarrow{S_{11C\_runtime}}$ and $VSWR_{C\_runtime}$.

RRU-level runtime
measurement

Fig.25

2600

Communication
module
2640

Processor
2610

Memory
2620

RAM
2622

ROM
2624
2630

Fig.26

2630

2700

Fig.27

Europäisches
Patentamt

European
Patent Office

Office européen
des brevets

# EUROPEAN SEARCH REPORT

Application Number

EP 23 18 7703

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 104 270 209 A (DATANG MOBILE TECHNOLOGIES CO) 7 January 2015 (2015-01-07) | 1,2,4,5, 10-12, 17-19 | INV. G01R27/28 G01R27/32 G01R35/00 |
| A | * the whole document * | 3,6-9, 13-16 | |
| X | CN 102 938 904 A (ZTE CORP) 20 February 2013 (2013-02-20) | 1,2,4,5, 10-12, 17-19 | |
| A | * the whole document * | 3,6-9, 13-16 | |
| X | CN 102 571 217 B (ZTE CORP) 10 December 2014 (2014-12-10) | 1,2,4,5, 10-12, 17-19 | |
| A | * the whole document * | 3,6-9, 13-16 | |
| A | WO 2020/217088 A1 (ERICSSON TELEFON AB L M [SE]; BADAWY AHMED [CA]) 29 October 2020 (2020-10-29) * paragraphs [0028], [0035] - [0044]; figures 1A-1B * | 1-19 | |

TECHNICAL FIELDS
SEARCHED (IPC)

G01R

The present search report has been drawn up for all claims

| Place of search | Date of completion of the search | Examiner |
|---|---|---|
| Munich | 19 December 2023 | Maric, Viktor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 18 7703

This annex lists the patent family members relating to the patent documents cited in the above-mentioned European search report.
The members are as contained in the European Patent Office EDP file on
The European Patent Office is in no way liable for these particulars which are merely given for the purpose of information.

19-12-2023

| Patent document cited in search report | | Publication date | Patent family member(s) | | Publication date |
|---|---|---|---|---|---|
| CN 104270209 | A | 07-01-2015 | NONE | | |
| CN 102938904 | A | 20-02-2013 | CN | 102938904 A | 20-02-2013 |
| | | | WO | 2012151939 A1 | 15-11-2012 |
| CN 102571217 | B | 10-12-2014 | NONE | | |
| WO 2020217088 | A1 | 29-10-2020 | NONE | | |

EPO FORM P0459

For more details about this annex : see Official Journal of the European Patent Office, No. 12/82